# EUROPEAN PATENT APPLICATION

(11) **EP 2 173 141 A1**
(43) Date of publication of application: **07.04.2010**
(21) Application number: 08753126.5
(22) Date of filing: 27.05.2008
(51) Int. Cl.: H05B 33/10, C09K 11/06, H01L 51/50

(54) **ORGANIC ELECTROLUMINESCENT DEVICE AND DISPLAY USING THE DEVICE**

(30) Priority: 30.05.2007 JP 2007143076
(71) Applicant: Sumitomo Chemical Company, Limited, Tokyo 104-8260 (JP)
(72) Inventor: ASADA, Kohei, Tsukuba-shi Ibaraki 305-0821 (JP)
(74) Representative: Duckworth, Timothy John
(86) International application number: PCT/JP2008/060110
(87) International publication number: WO 2008/149829

(57) **Abstract**

An organic EL device comprising an anode, a cathode, and an organic layer composed of at least two layers including a hole transporting layer and a light emitting layer, wherein at least one of the anode and the cathode is transparent or semitransparent, the organic layer is disposed in contact with the anode between the anode and the cathode, at least a portion of the surface of the anode ,the portion being in contact with the organic layer ,is treated with a specific organic compound, and/or, a layer that constituts the organic layer and that is in contact with the anode contains the organic compound; a sheet light source, a segment display and a dot matrix display having the above-described organic EL device, or a liquid crystal display having a backlight composed of the above-described organic EL device.

## Description

### Technical Field

The present invention relates to an organic electroluminescence device (hereinafter, referred to as organic EL device, in some cases.) and a display using the device.

### Background Art

Organic EL devices have a character that light emissions of a lot of colors are obtained easily in addition to driving at low voltage and high brightness, thus, are paid to attention as, for example, a member for displays of the next generation.

An organic EL device contains an anode, a cathode, and an organic layer having a light emitting layer. For enhancing the performance of the organic EL device, it is known to use, as the above-described organic layer, an organic layer having a hole transporting layer composed of poly(ethylenedioxythiophene)-polystyrenesulfonic acid (hereinafter, referred to as PEDOT:PSS) in addition to a light emitting layer.

### Disclosure of the Invention

However, since PEDOT:PSS is a strongly acidic watersoluble compound, alternative materials are required from the standpoint of production processes such as coating, film formation and the like.

As a result, an object of the present invention is to find the above-described alternative material from the standpoint of production processes such as coating, film formation and the like and to provide an organic electroluminescene device using the alternative material.

That is, in a first aspect, the present invention provides an organic electroluminescence device comprising
an anode,
a cathode, and
an organic layer composed of at least two layers including a hole transporting layer containing a polymer compound,the main chain of which contains repeating units each composed of an aromatic amine skeleton, and a light emitting layer containing a luminescent material and being capable of emitting light through recombination a hole and an electron, wherein
at least one of the anode and the cathode is transparent or semi-transparent,
the organic layer is disposed in contact with the anode between the anode and the cathode so as to contact with the
anode,
at least a portion of the surface of the anode ,the portion being in contact with the organic layer, is treated with an organic compound of the following formula (1):

(X)ᵥ₋₁-M-R¹ (1)

wherein each X represents a group or atom capable of reacting with a group or atom present on the surface of the anode to form a bond, M represents an atom of a metal element belonging to Group IV, Group V, Group VI, Group XIII, Group XIV or Group XV of the periodic table, R¹ represents independently an alkyl group, an aryl group, an arylalkyl group, an arylalkenyl group or an arylalkynyl group, and v represents the atomic valency of M.), and/or, a layer that constitutes the organic layer and that is in contact with the anode contains the organic compound.

In a second aspect, the present invention provides a sheet light source having the above-described organic electroluminescence device.

In a third aspect, the present invention provides a segment display having the above-described organic electroluminescence device.

In a fourth aspect, the present invention provides a dot matrix display having the above-described organic electroluminescence device.

In a fifth aspect, the present invention provides a liquid crystal display having a backlight composed of the above-described organic electroluminescence device.

### Modes for Carrying Out the Invention

### [Explanation of terms]

Terms commonly used in the present specification will be explained below.

Examples of the halogen atom include a fluorine atom, chlorine atom, bromine atom and iodine atom.

The term "Cₘ to Cₙ" (m, n are positive integers satisfying m<n) indicates that an organic group described together with this term has a carbon number of m to n.

The alkyl group means an unsubstituted alkyl group and an alkyl group substituted with a halogen atom, amino group, mercapto group or the like, and includes both linear alkyl groups and cyclic alkyl groups (cycloalkyl groups). The alkyl group may be branched. The alkyl group has a carbon atom number of usually 1 to 20, preferably 1 to 15, more preferably about 1 to 10. Examples thereof include a methyl group, ethyl group, propyl group, i-propyl group, butyl group, i-butyl group, s-butyl group, t-butyl group, pentyl group, hexyl group, cyclohexyl group, heptyl group, octyl group, 2-ethylhexyl group, nonyl group, decyl group, 3,7-dimethyloctyl group, lauryl group, trifluoromethyl group, pentafluoroethyl group, perfluorobutyl group, perfluorohexyl group, perfluorooctyl group, trifluoropropyl group, tridecafluoro-1,1,2,2-tetrahydrooctyl group, heptadecafluoro-1,1,2,2-tetrahydrodecyl group, aminopropyl group, aminooctyl group, aminodecyl group, mercaptopropyl group, mercaptooctyl group, mercaptodecyl group and the like. Examples of the C₁ to C₁₂alkyl group include a methyl group, ethyl group, propyl group, i-propyl group, butyl group, i-butyl group, s-butyl group, t-butyl group, pentyl group, isoamyl group, hexyl group, cyclohexyl group, heptyl group, octyl group, nonyl group, decyl group, dodecyl group and the like.

The alkoxy group means an unsubstituted alkoxy group and an alkoxy group substituted with a halogen atom, alkoxy group or the like, and includes both linear alkoxy groups and cyclic alkoxy groups (cycloalkoxy groups). The alkoxy group may be branched. The alkoxy group has a carbon atom number of usually 1 to 20, preferably 1 to 15, more preferably about 1 to 10. Examples thereof include a methoxy group, ethoxy group, propyloxy group, i-propyloxy group, butoxy group, i-butoxy group, t-butoxy group, pentyloxy group, hexyloxy group, cyclohexyloxy group, heptyloxy group, octyloxy group, 2-ethylhexyloxy group, nonyloxy group, decyloxy group, 3,7-dimethyloctyloxy group, lauryloxy group, trifluoromethoxy group, pentafluoroethoxy group, perfluorobutoxy group, perfluorohexyl group, perfluorooctyl group, methoxymethyloxy group, 2-methoxyethyloxy group and the like. Examples of the C₁ to C₁₂ alkoxy group include a methoxy group, ethoxy group, propyloxy group, i-propyloxy group, butoxy group, i-butoxy group, t-butoxy group, pentyloxy group, hexyloxy group, cyclohexyloxy group, heptyloxy group, octyloxy group, 2-ethylhexyloxy group, nonyloxy group, decyloxy group, 3,7-dimethyloctyloxy group, lauryloxy group and the like.

The alkylthio group means an unsubstituted alkylthio group and an alkylthio group substituted with a halogen atom or the like, and includes both linear alkylthio groups and cyclic alkylthio groups (cycloalkylthio groups). The alkylthio group may be branched. The alkylthio group has a carbon atom number of usually 1 to 20, preferably 1 to 15, more preferably about 1 to 10. Examples thereof include a methylthio group, ethylthio group, propylthio group, i-propylthio group, butylthio group, i-butylthio group, t-butylthio group, pentylthio group, hexylthio group, cyclohexylthio group, heptylthio group, octylthio group, 2-ethylhexylthio group, nonylthio group, decylthio group, 3,7-dimethyloctylthio group, laurylthio group, trifluoromethylthio group and the like. Examples of the C₁ to C₁₂ alkylthio group include a methylthio group, ethylthio group, propylthio group, i-propylthio group, butylthio group, i-butylthio group, t-butylthio group, pentylthio group, hexylthio group, cyclohexylthio group, heptylthio group, octylthio group, 2-ethylhexylthio group, nonylthio group, decylthio group, 3,7-dimethyloctylthio group, laurylthio group and the like.

The aryl group is an atomic group remaining after removing one hydrogen atom connected to a carbon atom constituting an aromatic ring from an aromatic hydrocarbon, and means an unsubstituted aryl group and an aryl group substituted with a halogen atom, alkoxy group, alkyl group or the like. The aryl group includes those having a condensed ring, and also those having two or more independent benzene rings or condensed rings connected via a single bond or a di-valent organic group, for example, an alkenylene group such as vinylene and the like. The aryl group has a carbon atom number of usually 6 to 60, preferably 7 to 48, more preferably about 7 to 30. Examples of the aryl group include a phenyl group, C₁ to C₁₂ alkoxyphenyl groups, C₁ to C₁₂ alkylphenyl groups, 1-naphthyl group, 2-naphthyl group, 1-anthracenyl group, 2-anthracenyl group, 9-anthracenyl group, pentafluorophenyl group and the like, and preferable are C₁ to C₁₂ alkoxyphenyl groups and C₁ to C₁₂ alkylphenyl groups.

Examples of the C₁ to C₁₂ alkoxyphenyl group include a methoxyphenyl group, ethoxyphenyl group, propyloxyphenyl group, i-propyloxyphenyl group, butoxyphenyl group, i-butoxyphenyl group, t-butoxyphenyl group, pentyloxyphenyl group, hexyloxyphenyl group, cyclohexyloxyphenyl group, heptyloxyphenyl group, octyloxyphenyl group, 2-ethylhexyloxyphenyl group, nonyloxyphenyl group, decyloxyphenyl group, 3,7-dimethyloctyloxyphenyl group, lauryloxyphenyl group and the like.

Examples of the C₁ to C₁₂ alkylphenyl group include a methylphenyl group, ethylphenyl group, dimethylphenyl group, propylphenyl group, mesityl group, methylethylphenyl group, i-propylphenyl group, butylphenyl group, i-butylphenyl group, t-butylphenyl group, pentylphenyl group, isoamylphenyl group, hexylphenyl group, heptylphenyl group, octylphenyl group, nonylphenyl group, decylphenyl group, dodecylphenyl group and the like.

The aryloxy group means an unsubstituted aryloxy group and an aryloxy group substituted with a halogen atom, alkoxy group, alkyl group or the like. The aryloxy group has a carbon atom number of usually 6 to 60, preferably 7 to 48, more preferably about 7 to 30. Examples thereof include a phenoxy group, C₁ to C₁₂ alkoxyphenoxy groups, C₁ to C₁₂ alkylphenoxy groups, 1-naphthyloxy group, 2-naphthyloxy group, pentafluorophenyloxy group and the like, and preferably C₁ to C₁₂ alkoxyphenoxy groups and C₁ to C₁₂ alkylphenoxy groups.

Examples of the C₁ to C₁₂ alkoxyphenoxy group include a methoxyphenoxy group, ethoxyphenoxy group, propyloxyphenoxy group, i-propyloxyphenoxy group, butoxyphenoxy group, i-butoxyphenoxy group, t-butoxyphenoxy group, pentyloxyphenoxy group, hexyloxyphenoxy group, cyclohexyloxyphenoxy group, heptyloxyphenoxy group, octyloxyphenoxy group, 2-ethylhexyloxyphenoxy group, nonyloxyphenoxy group, decyloxyphenoxy group, 3,7-dimethyloctyloxyphenoxy group, lauryloxyphenoxy group and the like.

Examples of the C₁ to C₁₂ alkylphenoxy group include a methylphenoxy group, ethylphenoxy group, dimethylphenoxy group, propylphenoxy group, 1,3,5-trimethylphenoxy group, methylethylphenoxy group, i-propylphenoxy group, butylphenoxy group, i-butylphenoxy group, t-butylphenoxy group, pentylphenoxy group, isoamylphenoxy group, hexylphenoxy group, heptylphenoxy group, octylphenoxy group, nonylphenoxy group, decylphenoxy group, dodecylphenoxy group and the like.

The arylthio group means an unsubstituted arylthio group and an arylthio group substituted with a halogen atom, alkoxy group, alkyl group or the like. The arylthio group has a carbon atom number of usually 6 to 60, preferably 7 to 48, more preferably about 7 to 30. Examples thereof include a phenylthio group, C₁ to C₁₂ alkoxyphenylthio groups, C₁ to C₁₂ alkylphenylthio groups, 1-naphthylthio group, 2-naphthylthio group, pentafluorophenylthio group and the like.

The arylalkyl group means an unsubstituted arylalkyl group and an arylalkyl group substituted with a halogen atom, alkoxy group, alkyl group and the like. The arylalkyl group has a carbon atom number of usually 7 to 60, preferably 7 to 48, more preferably about 7 to 30. Examples thereof include phenyl-C₁ to C₁₂ alkyl groups, C₁ to C₁₂ alkoxyphenyl-C₁ to C₁₂ alkyl groups, C₁ to C₁₂ alkylphenyl-C₁ to C₁₂ alkyl groups, 1-naphthyl-C₁ to C₁₂ alkyl groups, 2-naphthyl-C₁ to C₁₂ alkyl groups and the like.

The arylalkoxy group means an unsubstituted arylalkoxy group and an arylalkoxy group substituted with a halogen atom, alkoxy group, alkyl group or the like. The arylalkoxy group has a carbon atom number of usually 7 to 60, preferably 7 to 48, more preferably about 7 to 30. Examples thereof include phenyl-C₁ to C₁₂ alkoxy groups, C₁ to C₁₂ alkoxyphenyl-C₁ to C₁₂ alkoxy groups, C₁ to C₁₂ alkylphenyl-C₁ to C₁₂ alkoxy groups, 1-naphthyl-C₁ to C₁₂ alkoxy groups, 2-naphthyl-C₁ to C₁₂ alkoxy groups and the like.

The arylalkylthio group means an unsubstituted arylalkylthio group and an arylalkylthio group substituted with a halogen atom, alkoxy group, alkyl group or the like. The arylalkylthio group has a carbon atom number of usually 7 to 60, preferably 7 to 48, more preferably about 7 to 30. Examples thereof include phenyl-C₁ to C₁₂ alkylthio groups, C₁ to C₁₂ alkoxyphenyl-C₁ to C₁₂ alkylthio groups, C₁ to C₁₂ alkylphenyl-C₁ to C₁₂ alkylthio groups, 1-naphthyl-C₁ to C₁₂ alkylthio groups, 2-naphthyl-C₁ to C₁₂ alkylthio groups and the like.

The arylalkenyl group means an unsubstituted arylalkenyl group and an arylalkenyl group substituted with a halogen atom, alkoxy group, alkyl group or the like. The arylalkenyl group has a carbon atom number of usually 8 to 60, preferably 8 to 48, more preferably about 8 to 30. Examples thereof include phenyl-C₂ to C₁₂ alkenyl groups, C₁ to C₁₂ alkoxyphenyl-C₂ to C₁₂ alkenyl groups, C₁ to C₁₂ alkylphenyl-C₂ to C₁₂ alkenyl groups, 1-naphthyl-C₂ to C₁₂ alkenyl groups, 2-naphthyl-C₂ to C₁₂ alkenyl groups and the like, and preferably C₁ to C₁₂ alkoxyphenyl-C₂ to C₁₂ alkenyl groups and C₂ to C₁₂ alkylphenyl-C₂ to C₁₂ alkenyl groups.

Examples of the C₂ to C₁₂ alkenyl group include a vinyl group, 1-propenyl group, 2-propenyl group, 1-butenyl group, 2-butenyl group, 1-pentenyl group, 2-pentenyl group, 1-hexenyl group, 2-hexenyl group, 1-octenyl group and the like.

The arylalkynyl group means an unsubstituted arylalkynyl group and an arylalkynyl group substituted with a halogen atom, alkoxy group, alkyl group or the like. The arylalkynyl group has a carbon atom number of usually 8 to 60, preferably 8 to 48, more preferably about 8 to 30. Examples thereof include phenyl-C₂ to C₁₂ alkynyl groups, C₁ to C₁₂ alkoxyphenyl-C₂ to C₁₂ alkynyl groups, C₁ to C₁₂ alkylphenyl-C₂ to C₁₂ alkynyl groups, 1-naphthyl-C₂ to C₁₂ alkynyl groups, 2-naphthyl-C₂ to C₁₂ alkynyl groups and the like, and preferably C₁ to C₁₂ alkoxyphenyl-C₂ to C₁₂ alkynyl groups and C₁ to C₁₂ alkylphenyl-C₂ to C₁₂ alkynyl groups.

Examples of the C₂ to C₁₂ alkynyl group include an ethynyl group, 1-propynyl group, 2-propynyl group, 1-butynyl group, 2-butynyl group, 1-pentynyl group, 2-pentynyl group, 1-hexynyl group, 2-hexynyl group, 1-octynyl group and the like.

The mono-valent heterocyclic group indicates an atomic group remaining after removal of one hydrogen atom from a heterocyclic compound, and means an unsubstituted mono-valent heterocyclic group and a mono-valent heterocyclic group substituted with an alkyl group or the like. The mono-valent heterocyclic group has a carbon atom number of usually 4 to 60, preferably 4 to 30, more preferably about 4 to 20, not including the carbon atom number of the substituent. Here, the heterocyclic compound includes organic compounds having a cyclic structure in which elements constituting the ring include not only a carbon atom but also a hetero atom such as an oxygen atom, sulfur atom, nitrogen atom, phosphorus atom, boron atom, silicon atom, selenium atom, tellurium atom, arsenic atom and the like. Examples of the mono-valent heterocyclic group include a thienyl group, C₁ to C₁₂ alkylthienyl groups, pyrrolyl group, furyl group, pyridyl group, C₁ to C₁₂ alkylpyridyl groups, pyridazinyl group, pyrimidyl group, pyrazinyl group, triazinyl group, pyrrolidyl group, piperidyl group, quinolyl group, isoquinolyl group and the like, and of them, preferable are a thienyl group, C₁ to C₁₂ alkylthienyl groups, pyridyl group and C₁ to C₁₂ alkylpyridyl groups.

The heterocyclicthio group means a group obtained by substituting a hydrogen atom of a mercapto group with a mono-valent heterocyclic group. Examples of the heterocyclicthio group include heteroarylthio groups such as a pyridylthio group, pyridazinylthio group, pyrimidylthio group, pyrazinylthio group, triazinylthio group and the like.

The amino group means an unsubstituted amino group and an amino group substituted with one or two substituents selected from an alkyl group, aryl group, arylalkyl group and mono-valent heterocyclic group (hereinafter, referred to as substituted amino group). The substituent may further have a substituent (hereinafter, referred to as secondary substituent, in some cases). The substituted amino group has a carbon atom number of usually 1 to 60, preferably 2 to 48, more preferably about 2 to 40, not including the carbon atom number of the secondary substituent. Examples of the substituted amino group include a methylamino group, dimethylamino group, ethylamino group, diethylamino group, propylamino group, dipropylamino group, isopropylamino group, diisopropylamino group, butylamino group, isobutylamino group, s-butylamino group, t-butylamino group, pentylamino group, hexylamino group, heptylamino group, octylamino group, 2-ethylhexylamino group, nonylamino group, decylamino group, 3,7-dimethyloctylamino group, dodecylamino group, cyclopentylamino group, dicyclopentylamino group, cyclohexylamino group, dicyclohexylamino group, ditrifluoromethylamino group, phenylamino group, diphenylamino group, C₁ to C₁₂ alkoxyphenylamino groups, di(C₁ to C₁₂ alkoxyphenyl)amino groups, C₁ to C₁₂ alkylphenylamino groups, di (C₁ to C₁₂ alkylphenyl)amino groups, 1-naphthylamino group, 2-naphthylamino group, pentafluorophenylamino group, pyridylamino group, pyridazinylamino group, pyrimidylamino group, pyrazinylamino group, triazinylamino group, phenyl-C₁ to C₁₂ alkylamino groups, C₁ to C₁₂ alkoxyphenyl-C₁ to C₁₂ alkylamino groups, di(C₁ to C₁₂ alkoxyphenyl-C₁ to C₁₂ alkyl)amino groups, C₁ to C₁₂ alkylphenyl-C₁ to C₁₂ alkylamino groups, di (C₁ to C₁₂ alkylphenyl-C₁ to C₁₂ alkyl)amino groups, 1-naphthyl-C₁ to C₁₂ alkylamino groups, 2-naphthyl-C₁ to C₁₂ alkylamino groups and the like.

The silyl group means an unsubstituted silyl group and a silyl group substituted with one, two or three substituents selected from an alkyl group, aryl group, arylalkyl group and mono-valent heterocyclic group (hereinafter, referred to as substituted silyl group). The substituent may have a secondary substituent. The substituted silyl group has a carbon atom number of usually 1 to 60, preferably 3 to 48, more preferably about 3 to 40, not including the carbon atom number of the secondary substituent. Examples of the substituted silyl group include a trimethylsilyl group, triethylsilyl group, tripropylsilyl group, tri-isopropylsilyl group, dimethylisopropylsilyl group, diethyl-isopropylsilyl group, t-butylsilyldimethylsilyl group, pentyldimethylsilyl group, hexyldimethylsilyl group, heptyldimethylsilyl group, octyldimethylsilyl group, 2-ethylhexyl-dimethylsilyl group, nonyldimethylsilyl group, decyldimethylsilyl group, 3,7-dimethyloctyl-dimethylsilyl group, dodecyldimethylsilyl group, phenyl-C₁ to C₁₂ alkylsilyl groups, C₁ to C₁₂ alkoxyphenyl-C₁ to C₁₂ alkylsilyl groups, C₁ to C₁₂ alkylphenyl-C₁ to C₁₂ alkylsilyl groups, 1-naphthyl-C₁ to C₁₂ alkylsilyl groups, 2-naphthyl-C₁ to C₁₂ alkylsilyl groups, phenyl-C₁ to C₁₂ alkyldimethylsilyl groups, triphenylsilyl group, tri-p-xylylsilyl group, tribenzylsilyl group, diphenylmethylsilyl group, t-butyldiphenylsilyl group, dimethylphenylsilyl group and the like.

The acyl group means an unsubstituted acyl group and an acyl group substituted with a halogen atom or the like. The acyl group has a carbon atom number of usually 1 to 20, preferably 2 to 18, more preferably about 2 to 16. Examples of the acyl group include a formyl group, acetyl group, propionyl group, butylyl group, isobutylyl group, pivaloyl group, benzoyl group, trifluoroacetyl group, pentafluorobenzoyl group and the like.

The acyloxy group means an unsubstituted acyloxy group and an acyloxy group substituted with a halogen atom or the like. The acyloxy group has carbon atom number of usually 1 to 20, preferably 2 to 18, more preferably about 2 to 16. Examples of the acyloxy group include a formyloxy group, acetoxy group, propionyloxy group, butylyloxy group, isobutylyloxy group, pivaloyloxy group, benzoyloxy group, trifluoroacetyloxy group, pentafluorobenzoyloxy group and the like.

The imine residue means a residue obtained by removing, from an imine compound having a structure represented by at least one of the formula: H-N=C< and the formula: -N=CH-, one hydrogen atom in this structure. Examples of such an imine compound include aldimines and ketimines, and compounds obtained by substitution of a hydrogen atom connected to a nitrogen atom in aldimines with an alkyl group, aryl group, arylalkyl group, arylalkenyl group, arylalkynyl group or the like. The imine residue has carbon atom number of usually 2 to 20, preferably 2 to 18, more preferably about 2 to 16. Examples of the imine residue include groups represented by the formula: -CR'=N-R" or the formula: -N=C(R")2 (wherein, R' represents a hydrogen atom, alkyl group, aryl group, arylalkyl group, arylalkenyl group or arylalkynyl group, R''s represent independently an alkyl group, aryl group, arylalkyl group, arylalkenyl group or arylalkynyl group, and when there exist two R"s, two R"s may be mutually connected and integrated to form a ring as a di-valent group, for example, an alkylene group having 2 to 18 carbon atoms such as an ethylene group, trimethylene group, tetramethylene group, pentamethylene group, hexamethylene group and the like.), and examples of the imine residue include groups of the following structural formulae, and the like. 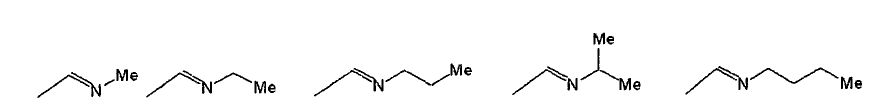 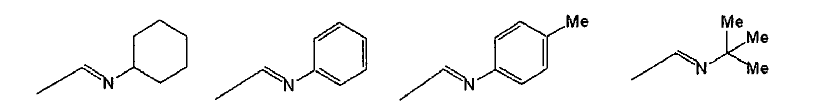 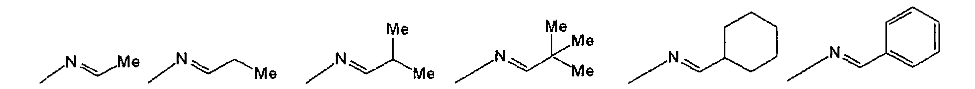 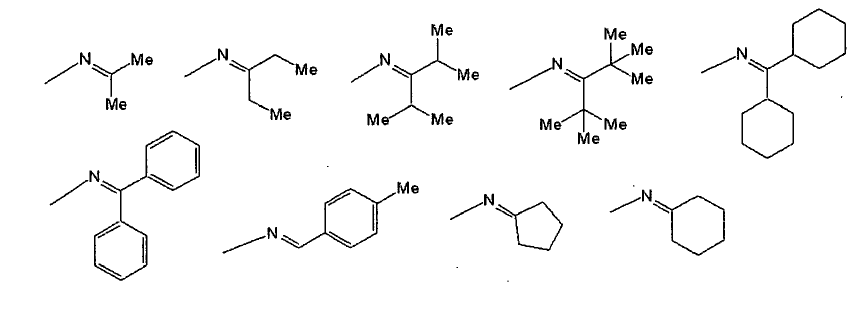 (wherein, Me represents a methyl group.)

The amide group means an unsubstituted amide group and an amide group substituted with a halogen atom or the like 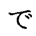 substituted. The amide group has a carbon atom number of usually 2 to 20, preferably 2 to 18, more preferably about 2 to 16. Examples of the amide group include a formamide group, acetamide group, propioamide group, butyroamide group, benzamide group, trifluoroacetamide group, pentafluorobenzamide group, diformamide group, diacetamide group, dipropioamide group, dibutyroamide group, dibenzamide group, ditrifluoroacetamide group, dipentafluorobenzamide group and the like.

The acid imide group means a residue obtained by removing from an acid imide a hydrogen atom connected to its nitrogen atom. The acid imide group has a carbon atom number of usually 4 to 20, preferably 4 to 18, more preferably about 4 to 16. Examples of the acid imide group include groups shown below, and the like. 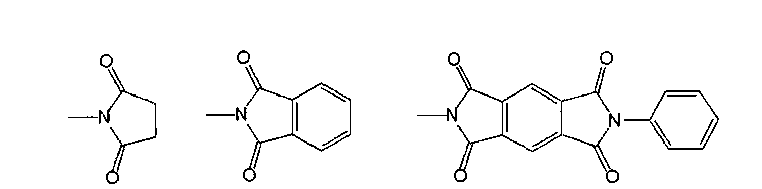 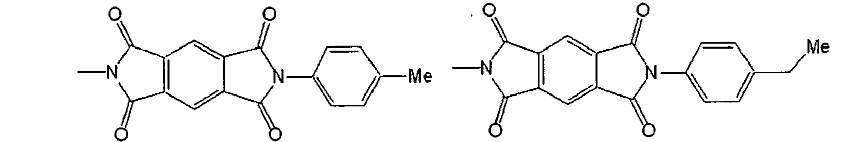 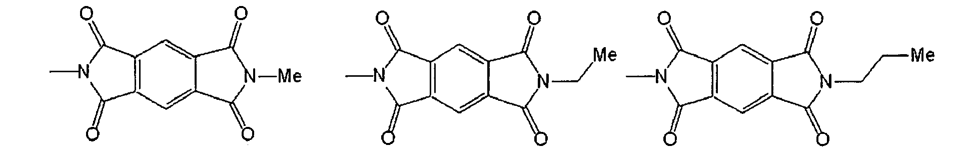 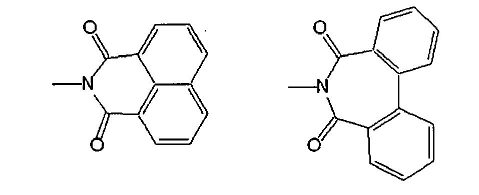 (wherein, Me represents a methyl group.)

The carboxyl group means an unsubstituted carboxyl group and a carboxyl group substituted with an alkyl group, aryl group, arylalkyl group, mono-valent heterocyclic group or the like (hereinafter, referred to as substituted carboxyl group.). The substituent may have a secondary substituent. The substituted carboxyl group has a carbon atom number of usually 1 to 60, preferably 2 to 48, more preferably about 2 to 45, not including the carbon atom number of the secondary substituent. Examples of the substituted carboxyl group include a methoxycarbonyl group, ethoxycarbonyl group, propoxycarbonyl group, isopropoxycarbonyl group, butoxycarbonyl group, isobutoxycarbonyl group, s-butoxycarbonyl group, t-butoxycarbonyl group, pentyloxycarbonyl group, hexyloxycarbonyl group, cyclohexyloxycarbonyl group, heptyloxycarbonyl group, octyloxycarbonyl group, 2-ethylhexyloxycarbonyl group, nonyloxycarbonyl group, decyloxycarbonyl group, 3,7-dimethyloctyloxycarbonyl group, dodecyloxycarbonyl group, trifluoromethoxycarbonyl group, pentafluoroethoxycarbonyl group, perfluorobutoxycarbonyl group, perfluorohexyloxycarbonyl group, perfluorooctyloxycarbonyl group, phenoxycarbonyl group, naphthoxycarbonyl group, pyridyloxycarbonyl group and the like.

### [Organic compound having a group capable of reacting with a group or atom present on the surface of an anode to form a bond]

In the organic EL device of the present invention, the organic compound used for treatment of the surface of an anode, and/or, added to a layer in contact with an anode constituting an organic layer is an organic compound of the following formula (1):

(X)ᵥ₋₁-M-R¹ (1)

(wherein, X represents a group or atom capable of reacting with a group or atom present on the surface of the anode to form a bond, M represents an atom of metal elements belonging to group IV, group V, group VI, group XIII, group XIV or group XV of the periodic table, R¹ represents independently an alkyl group, aryl group, arylalkyl group, arylalkenyl group or arylalkynyl group, and v represents the atomic valency of M.). The organic compound may be used singly or in combination with another or more.

The above-described X is a group or atom capable of reacting with a group or atom present on the surface of an anode to form a bond. X can be appropriately selected depending on a group or atom present on the surface of an anode. When the anode is constituted of a metal or its oxide or sulfide, examples of X include a hydroxyl group, carboxyl group, acyl group, acyloxy group, halocarbonyl group (meaning a group of the formula: -C(O)-Y (wherein, Y represents a halogen atom), and preferable are groups of the formula: -C(O)-Cl and the formula: -C(O)-Br), halogen atom, alkoxy group, aryloxy group, arylalkoxy group, phosphoric residue (group of the formula: (HO)₂P(O)-O-), phosphate residue (group of the formula: (R¹O)₂P(O)-O- or the formula: (R¹O)(HO)P(O)-O- (wherein, R¹ is as described above)), phosphorous residue (group of the formula: (HO)₂P-O-), phosphite residue (group of the formula: (R¹O)₂P-O- or the formula: (R¹O)(HO)P-O- (wherein, R¹ is as described above)), mercapto group, alkylthio group, arylthio group, arylalkylthio group, heterocyclicthio group, amino group and the like. By reaction of X with a group or atom present on the surface of an anode, a bond such as a covalent bond, coordinate bond, ion bond and the like is formed between an organic compound of the above-described formula (1) and an anode. As the anode, a thin film made of an electrically conductive inorganic oxide or metal is generally utilized, and its surface often has a hydroxyl group, thus, it is preferable that X is a group or atom which is capable of reacting with a hydroxyl group, for example, a halogen atom, alkoxy group, phosphoric residue, or amino group.

Though X may react directly with a group or atom present on the surface of an anode, it may also react indirectly via other substance. If this other substance is allowed to coexist in reacting X with a group or atom present on the surface of an anode, the indirect reaction as described above may occur. As this other substance, compounds are mentioned having both a group or atom reacting directly with a group or atom present on the surface of an anode, and a group or atom reacting directly with X.

In the above-described formula (1), M represents an atom of metal elements belonging to group IV, group V, group VI, group XIII, group XIV or group XV of the periodic table. Here, the metal elements include also half metallic elements such as boron, silicon, germanium, phosphorus, arsenic, antimony, bismuth and the like. That is, examples of M include atoms of metal elements belonging to group IV such as titanium, zirconium, hafnium and the like; atoms of metal elements belonging to group V such as vanadium, niobium, tantalum and the like; atoms of metal elements belonging to group VI such as chromium, molybdenum, tungsten and the like; atoms of metal elements belonging to group XIII such as boron, aluminum, gallium, indium, thallium and the like; atoms of metal elements belonging to group XIV such as silicon, germanium, tin, lead and the like; atoms of metal elements belonging to group XV such as phosphorus, arsenic, antimony, bismuth and the like. Of them, preferable are a silicon atom, tin atom, titanium atom, zirconium atom, aluminum atom, niobium atom, boron atom and phosphorus atom, more preferable are a silicon atom, zirconium atom, aluminum atom, boron atom, titanium atom and phosphorus atom, still more preferable are a silicon atom, titanium atom and phosphorus atom.

In the above-described formula (1), R¹ represents independently an alkyl group, aryl group, arylalkyl group, arylalkenyl group or arylalkynyl group.

The above-described v represents the atomic valency of M, and values thereof are known to those skilled in the art for each of the above-described metal elements. For example, when M represents a silicon atom, titanium atom, zirconium atom or the like, v is 4, and M represents boron, aluminum or the like, v is 3.

In one preferable embodiment of the present invention, a hydroxyl group is present on the surface of the above-described anode, and the organic compound of the above-described formula (1) includes either one or both of a silage coupling agent of the following formula (2):

(X)₃-Si-R¹ (2)

(wherein, X and R¹ are as described above.) and a titanium coupling agent of the following formula (3):

(X)₃-Ti-R¹ (3)

(wherein, X and R¹ are as described above.) In this case, X represents particularly preferably a halogen atom, alkoxy group, phosphoric residue or amino group. R¹ represents particularly preferably an alkyl group or aryl group.

In another preferable embodiment of the present invention, the organic compound of the above-described formula (1) is an organic compound of the following formula (4):

(A)₃-Si-B (4)

(wherein, A's represent independently a chlorine atom or hydroxyl group, and B represents an alkyl group having 2 to 10 carbon atoms).

Examples of the organic compound of the above-described formula (1) are as described below.

Examples of the silane coupling agent include alkoxysilane coupling agents such as propyltrimethoxysilane, octyltrimethoxysilane, decyltrimethoxysilane, aminopropyltrimethoxysilane, aminooctyltrimethoxysilane, aminodecyltrimethoxysilane, mercaptopropyltrimethoxysilane, mercaptooctyltrimethoxysilane, mercaptodecyltrimethoxysilane, propyltriethoxysilane, octyltriethoxysilane, decyltriethoxysilane, aminopropyltriethoxysilane, aminooctyltriethoxysilane, aminodecyltriethoxysilane, mercaptopropyltriethoxysilane, mercaptooctyltriethoxysilane, mercaptodecyltriethoxysilane and the like; chlorosilane coupling agents such as propyltrichlorosilane, octyltrichlorosilane, decyltrichlorosilane, aminopropyltrichlorosilane, aminooctyltrichlorosilane, aminodecyltrichlorosilane, mercaptopropyltrichlorosilane, mercaptooctyltrichlorosilane, mercaptodecyltrichlorosilane and the like; and fluorinated alkylsilanes such as heptadecafluoro-1,1,2,2-tetrahydrodecyltriethoxysilane, heptadecafluoro-1,1,2,2-tetrahydrodecyltrimethoxysilane, heptadecafluoro-1,1,2,2-tetrahydrodecyltrichlorosilane, tridecafluoro-1,1,2,2,tetrahydrooctyltriethoxysilane, tridecafluoro-1,1,2,2-tetraoctyltritrimethoxysilane, tridecafluoro-1,1,2,2-tetrahydrooctyltrichlorosilane, trifluoropropyltrimethoxysilane and the like. These silane coupling agents may be used singly or in combination with another or more. Of them, fluorinated alkylsilanes are preferable.

Examples of the titanium coupling agent include propyltrimethoxytitanium, octyltrimethoxytitanium, aminopropyltrimethoxytitanium, aminodecyltrimethoxytitanium, mercaptopropyltrimethoxytitanium, mercaptooctyltrimethoxytitanium, aminopropyltriethoxytitanium, mercaptopropyltriethoxytitanium, mercaptodecyltriethoxytitanium, propyltrichlorotitanium, octyltrichlorotitanium, decyltrichlorotitanium, aminopropyltrichlorotitanium, mercaptopropyltrichlorotitanium, mercaptooctyltrichlorotitanium, heptadecafluoro-1,1,2,2-tetrahydrodecyltriethoxytitanium, and heptadecafluoro-1,1,2,2-tetrahydrodecyltrichlorotitanium. These titanium coupling agents may be used singly or in combination with another or more.

As the organic compound which is capable of reacting directly or indirectly with a group or atom present on an anode of an organic electroluminescence device used in the present invention, there can also be used phosphonate compounds ((R¹O)₂P(O)-R¹); acidic phosphonate compounds ((R¹O)(HO)P(O)-R¹), phosphonic compounds ((HO)₂P(O)-R¹), phosphonite compounds ((R¹O)₂P-R¹), acidic phosphonite compounds ((R¹O)(HO)P-R¹), phosphonous compounds ((HO)₂P-R¹) (in these six formulae, R¹ is as described above.).

In the organic EL device of the present invention, at least a portion in contact with an organic layer of the surface of an anode is treated with an organic compound of the above-described formula (1), or a layer in contact with an anode constituting an organic layer contains the above-described organic compound, alternatively, at least a portion in contact with an organic layer of the surface of an anode is treated with the above-described organic compound and a layer in contact with an anode constituting an organic layer contains the above-described organic compound.

As the method of treating at least a portion in contact with an organic layer of the surface of an anode in the organic EL device of the present invention with the above-described organic compound, there is a method in which the above-described organic compound is dissolved in a solvent, the anode is immersed in the resultant solution and a group X (namely, hydrophilic portion) in the organic compound is reacted with the anode, then, the anode is separated from the solution, and the anode is washed with the solvent used for dissolving the organic compound, thereby, removing the unreacted organic compound.

The solvent used for dissolving the above-described organic compound is not particularly restricted providing it does not react with the organic compound, and examples of the above-described solvent include chlorine-based solvents such as chloroform, methylene chloride, 1,2-dichloroethane, 1,1,2-trichloroethane, chlorobenzene, o-dichlorobenzene and the like; ether solvents such as tetrahydrofuran, dioxane and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketone solvents such as acetone, methyl ethyl ketone, cyclohexanone and the like; ester solvents such as ethyl acetate, butyl acetate, ethylcellosolve acetate and the like; polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof; alcohol solvents such as methanol, ethanol, propanol, isopropanol, cyclohexanol and the like; sulfoxide solvents such as dimethyl sulfoxide and the like. The above-described solvents may be used singly or in combination with another or more.

Though the concentration of the organic compound in the solution obtained by dissolving the organic compound of the above-described formula (1) in a solvent is not particularly restricted, when the concentration is low, the reaction of the organic compound with an anode needs longer period of time in some cases, thus, low concentration is not preferable, and when the concentration is high, film formability lowers due to mutual coagulation of molecules of the organic compound in some cases, thus, high concentration is not preferable. Therefore, the concentration of the organic compound is preferably in, but not limited to, a range of 0.01 to 100 mmol/l.

Though the temperature at which the organic compound of the above-described formula (1) and an anode are reacted is not particularly restricted, it is preferable in a range of 10 to 50°C. Though the time necessary for the reaction is also not particularly restricted, it is preferably in a range of 1 minute to 24 hours in general.

### [Hole transportable polymer material]

In the organic EL device of the present invention, the polymer compound containing a repeating unit composed of an aromatic amine skeleton in its main chain contains the repeating unit composed of an aromatic amine skeleton in a proportion of 30 mol% or more and 100 mole% or less with respect to all repeating units in the polymer compound, and used to transporting holes in an organic layer, and particularly when a hole transporting layer containing the polymer compound comes into contact with an anode, the polymer compound is used also for injecting holes from the anode into the organic layer efficiently. It is preferable that the proportion of the repeating unit composed of an aromatic amine skeleton is 40 mol% or more and 100 mol% or less, preferably 50 mol% or more and 85 mol% or less, from the standpoint of enhancement of hole transportability. It is further preferable that, as the polymer compound, an aromatic amine copolymer is used containing a repeating unit composed of an aromatic amine skeleton and other repeating units composed of a conjugated compound residue having an aromatic hydrocarbon ring and/or aromatic heterocyclic ring.

As the above-described repeating unit composed of an aromatic amine skeleton, preferable are repeating units of the following formula (5): 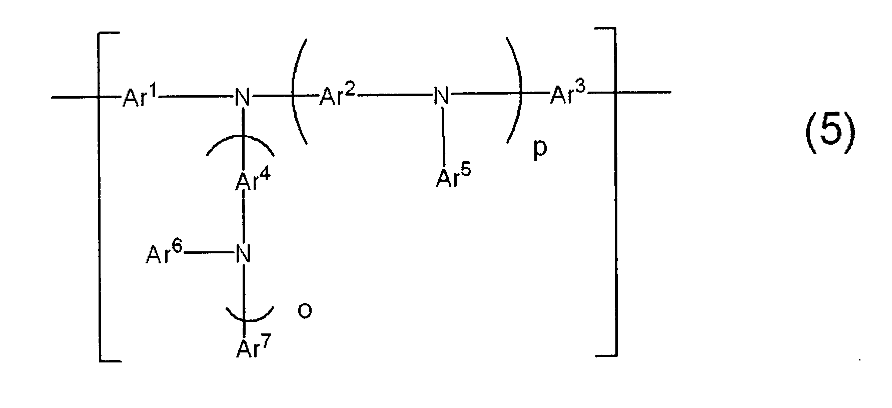 (wherein, Ar¹, Ar², Ar³ and Ar⁴ represent independently an arylene group or di-valent heterocyclic group. Ar⁵, Ar⁶ and Ar⁷ represent independently an aryl group or mono-valent heterocyclic group. Alternatively, Ar⁶ and Ar⁷ may together form a ring with a nitrogen atom to which Ar⁶ and Ar⁷ are connected, instead of representation of the above-described groups. o and p represent independently 0 or 1.).

Examples of the arylene group in the above-described formula (5) include a phenylene group, biphenylene group, terphenylene group, naphthalenediyl group, anthracenediyl group, phenanthrenediyl group, pentalenediyl group, indenediyl group, heptalenediyl group, indacenediyl group, triphenylenediyl group, binaphthyldiyl group, phenylnaphthylenediyl group, stilbenediyl group, fluorenediyl group and the like. Examples of the di-valent heterocyclic group (di-valent heterocyclic group means an atomic group obtained by removing two hydrogen atoms from a heterocyclic compound) include a pyridinediyl group, diazaphenylene group, quinolinediyl group, quinoxalinediyl group, acridinediyl group, bipyridyldiyl group, phenanthrolinediyl group and the like. The aryl group has a carbon atom number of usually 6 to 60, and examples thereof include a phenyl group and the like. The mono-valent heterocyclic group means an atomic group obtained by removing one hydrogen atom from a heterocyclic compound, and examples thereof include a pyridyl group and the like.

As examples of the repeating unit of the above-described formula (5), repeating units of the following formulae are mentioned.

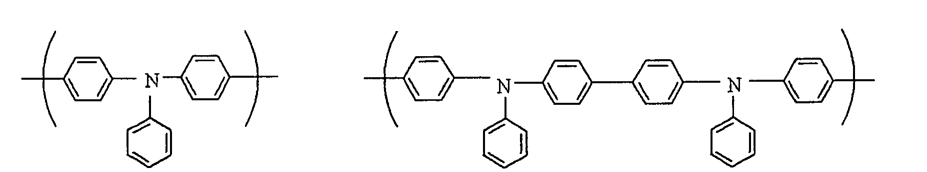

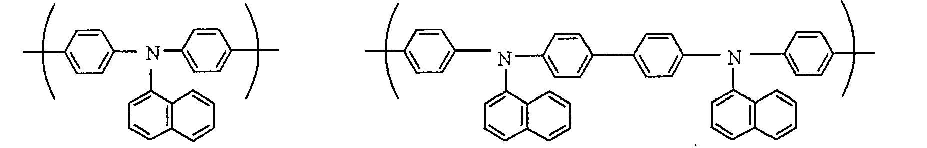

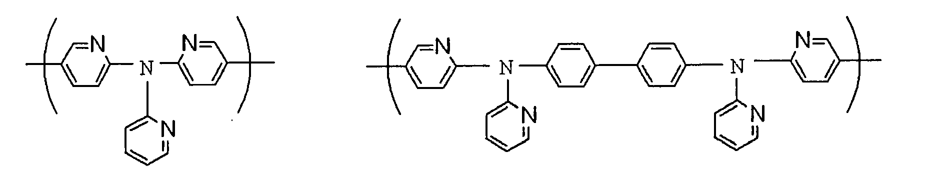

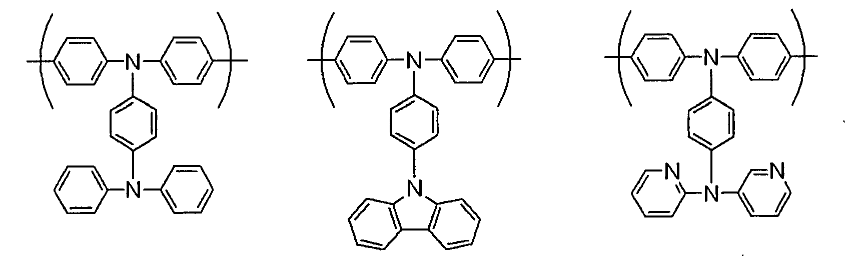

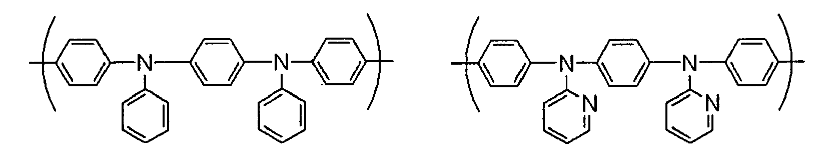

In the above-described formulae, hydrogen atoms on aromatic hydrocarbon rings and aromatic heterocyclic rings may be independently substituted with an alkyl group having a carbon atom number of 1 to 20, an alkoxy group having a carbon atom number of 1 to 20, a phenylalkyl group having a carbon atom number of 7 to 26, a phenylalkoxy group having a carbon atom number of 7 to 26, a phenyl group, a phenoxy group, an alkyl group-substituted phenyl group having a carbon atom number of 7 to 26, an alkoxy group-substituted phenyl group having a carbon atom number of 7 to 26, an alkylcarbonyl group having a carbon atom number of 2 to 21, a formyl group, an alkoxycarbonyl group having a carbon atom number of 2 to 21, or a carboxyl group. When there exist two substituents, these may be mutually connected to form a ring.

As the phenylalkyl group, for example, those having a carbon atom number of usually 7 to 26, preferably 11 to 21, more preferably 14 to 18 are mentioned, and examples thereof include a phenylmethyl group, phenylethyl group, phenylpropyl group, phenylbutyl group, phenylpentyl group, phenylhexyl group, phenylheptyl group, phenyloctyl group, phenylnonyl group, phenyldecyl group, phenyldodecyl group and the like.

As the phenylalkoxy group, for example, those having a carbon atom number of usually 7 to 26, preferably 11 to 21, more preferably 14 to 18 are mentioned, and examples thereof include a phenylmethoxy group, phenylethoxy group, phenylpropyloxy group, phenylbutoxy group, phenylpentyloxy group, phenylhexyloxy group, phenylheptyloxy group, phenyloctyloxy group, phenylnonyloxy group, phenyldecyloxy group, phenyldodecyloxy group and the like.

The alkyl group-substituted phenyl group includes groups obtained by substituting at least one hydrogen atom on a phenyl group with an alkyl group having a carbon atom number of 1 to 20, namely, a monoalkylphenyl group, dialkylphenyl group, trialkylphenyl group, tetraalkylphenyl group and pentaalkylphenyl group. As the alkyl group-substituted phenyl group, for example, those having a carbon atom number of usually 7 to 26, preferably 11 to 21, more preferably 14 to 18 are mentioned, and examples thereof include mono, di, tri, tetra or penta-methylphenyl group; mono, di, tri, tetra or penta-ethylphenyl group; mono, di, tri, tetra or penta-propylphenyl group; mono, di, tri, tetra or penta-isopropylphenyl group; mono, di, tri, tetra or penta-butylphenyl group; mono, di, tri, tetra or penta-isobutylphenyl group; mono, di, tri, tetra or penta-s-butylphenyl group; mono, di, tri, tetra or penta-t-butylphenyl group; mono, di, tri, tetra or penta-pentylphenyl group; mono, di, tri, tetra or penta-isoamylphenyl group; mono, di, tri, tetra or penta-hexylphenyl group; mono, di, tri, tetra or penta-heptylphenyl group; mono, di, tri, tetra or penta-octylphenyl group; mono, di, tri, tetra or penta-(2-ethylhexyl)phenyl group; mono, di, tri, tetra or penta-nonylphenyl group; mono, di, tri, tetra or penta-decylphenyl group; mono, di, tri, tetra or penta-(3,7-dimethyloctyl)phenyl group; mono, di, tri, tetra or penta-dodecylphenyl group, and the like.

The alkoxy group-substituted phenyl group includes groups obtained by substituting at least one hydrogen atom on a phenyl group with an alkoxy group having a carbon atom number of 1 to 20, namely, a monoalkoxyphenyl group, dialkoxyphenyl group, trialkoxyphenyl group, tetraalkoxyphenyl group and pentaalkoxyphenyl group. As the alkoxy group-substituted phenyl group, for example, those having a carbon atom number of usually 7 to 26, preferably 11 to 21, more preferably 14 to 18 are mentioned, and examples thereof include mono, di, tri, tetra or penta-methoxyphenyl group; mono, di, tri, tetra or penta-ethoxyphenyl group; mono, di, tri, tetra or penta-propyloxyphenyl group; mono, di, tri, tetra or penta-isopropyloxyphenyl group; mono, di, tri, tetra or penta-butoxyphenyl group; mono, di, tri, tetra or penta-isobutoxyphenyl group; mono, di, tri, tetra or penta-s-butoxyphenyl group; mono, di, tri, tetra or penta-t-butoxyphenyl group; mono, di, tri, tetra or penta-pentyloxyphenyl group; mono, di, tri, tetra or penta-hexyloxyphenyl group; mono, di, tri, tetra or penta-heptyloxyphenyl group; mono, di, tri, tetra or penta-octyloxyphenyl group; mono, di, tri, tetra or penta-(2-ethylhexyloxy)phenyl group; mono, di, tri, tetra or penta-nonyloxyphenyl group; mono, di, tri, tetra or penta-decyloxyphenyl group; mono, di, tri, tetra or penta-(3,7-dimethyloctyloxy)phenyl group; mono, di, tri, tetra or penta-dodecyloxyphenyl group, and the like.

As the alkylcarbonyl group, for example, those having a carbon atom number of usually 2 to 21, preferably 5 to 15, more preferably 8 to 12 are mentioned, and examples thereof include an acetyl group, propionyl group, butyryl group, isobutyryl group, pentanoyl group, hexanoyl group, heptanoyl group, octanoyl group, 2-ethylhexanoyl group, nonanoyl group, decanoyl group, 3,7-dimethyloctanoyl group, dodecanoyl group and the like.

As the alkoxycarbonyl group, for example, those having a carbon atom number of usually 2 to 21, preferably 5 to 15, more preferably 8 to 12 are mentioned, and examples thereof include a methoxycarbonyl group, ethoxycarbonyl group, propyloxycarbonyl group, isopropyloxycarbonyl group, butoxycarbonyl group, isobutoxycarbonyl group, s-butoxycarbonyl group, t-butoxycarbonyl group, pentyloxycarbonyl group, hexyloxycarbonyl group, heptyloxycarbonyl group, octyloxycarbonyl group, 2-ethylhexyloxycarbonyl group, nonyloxycarbonyl group, decyloxycarbonyl group, 3,7-dimethyloctyloxycarbonyl group, dodecyloxycarbonyl group, and the like.

Among the repeating units of the above-described formula (5), preferable are repeating units of the following formula (6): 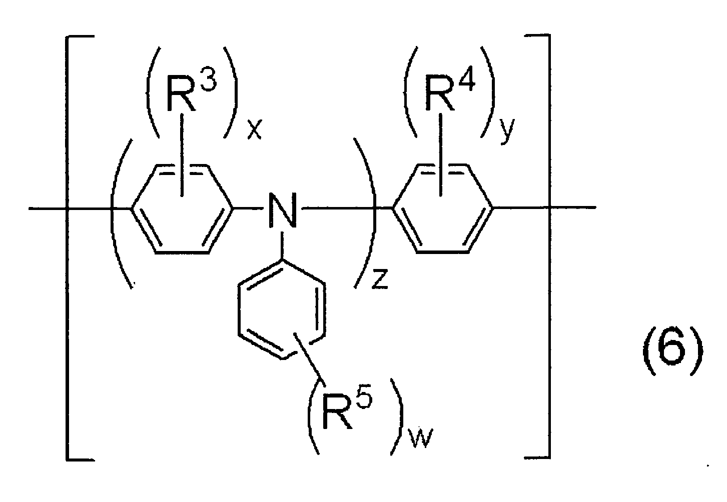 (wherein, R³, R⁴ and R⁵ represent independently an alkyl group having a carbon atom number of 1 to 20, an alkoxy group having a carbon atom number of 1 to 20, a phenylalkyl group having a carbon atom number of 7 to 26, a phenylalkoxy group having a carbon atom number of 7 to 26, a phenyl group, a phenoxy group, an alkyl group-substituted phenyl group having a carbon atom number of 7 to 26, an alkoxy group-substituted phenyl group having a carbon atom number of 7 to 26, an alkylcarbonyl group having a carbon atom number of 2 to 21, a formyl group, an alkoxycarbonyl group having a carbon atom number of 2 to 21 or a carboxyl group. Alternatively, R³ and R⁴ may together form a ring, instead of representation of the above-described groups. x and y represent independently an integer of 0 to 4, z represents 1 or 2, and w represents an integer of 0 to 5. When there exist at least one of a plurality of R³'s, R⁴'s and R⁵'s, these plurality of groups may be the same or different.).

When R³ and R⁴ in the above-described formula (6) together form a ring instead of representation of the above-described groups, examples of the ring include C₅ to C₁₄ heterocyclic rings optionally having a substituent. Examples of the heterocyclic ring include a morpholine ring, thiomorpholine ring, pyrrole ring, piperidine ring, piperazine ring and the like.

Examples of such repeating units of the formula (6) include repeating units of the following formulae (6-1) to (6-10).

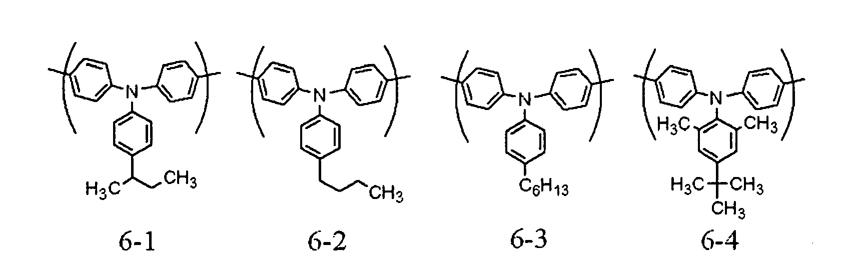

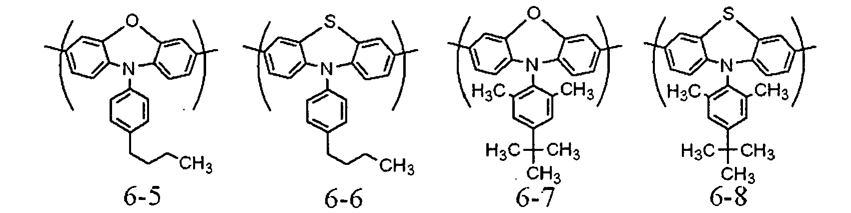

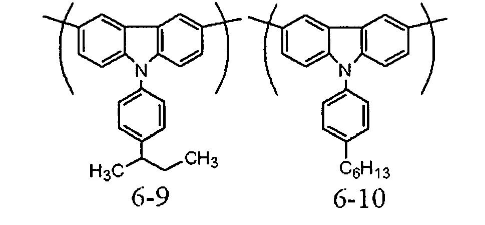

As the repeating unit of the above-described formula (6), preferable are repeating units of the following formula (7): 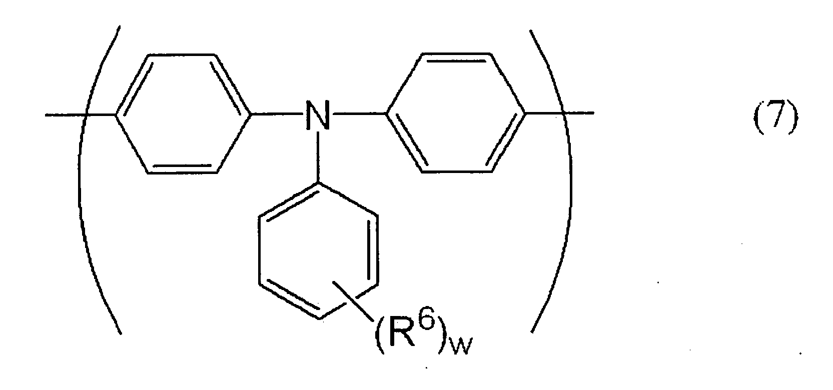 (wherein, R⁶ represents an alkyl group having a carbon atom number of 1 to 20, and w represents an integer of 0 to 5. When there exist a plurality of R⁶'s, these may be the same or different.)
from the standpoint of the solubility of the hole transportable polymer material in a solvent, easiness of synthesis of the "repeating unit composed of an aromatic amine skeleton", hole transportability, and ionization potential.

If a polymerization active group remains intact on the end part of the above-described polymer compound containing a repeating unit composed of an aromatic amine skeleton, when it is used for fabrication of a device, there is a possibility of lowering of light emission property and life of the resultant device, thus, the end part is preferably protected by a stable protective group. As the protective group, those having a conjugated bond continuous to a conjugated structure of the main chain are preferable, and for example, structures in which an aryl group or mono-valent heterocyclic group is connected via a carbon-carbon bond to the main chain are mentioned. Specific examples include substituents described in JP-A No. 9-45478, chemical formula 10, and the like.

In the organic EL device of the present invention, it is preferable that the polymer compound containing a repeating unit composed of an aromatic amine skeleton in the main chain contains in its main chain at least one repeating unit of the following formula (8) together with the above-described at least one repeating unit composed of an aromatic amine skeleton, from the standpoint of device properties such as maximum light emission efficiency, device life and the like.

-Ar⁸- (8)

(wherein, Ar⁸ represents an arylene group).

In the above-described formula (8), the arylene group indicates a remaining atomic group obtained by removing from an aromatic hydrocarbon two hydrogen atoms connected to a carbon atom constituting the aromatic ring, and means an unsubstituted arylene group and substituted arylene group. The arylene group includes those having a condensed ring, and also those having two or more independent benzene rings or condensed rings connected via a single bond or a di-valent organic group, for example, an alkenylene group such as vinylene and the like.

Though the substituted atom and substituted group in the substituted arylene group are not particularly restricted, preferable are halogen atom, alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclicthio group, amino group, silyl group, acyl group, acyloxy group, imine residue, amide group, acid imide group, carboxyl group, cyano group or nitro group, from the standpoint of solubility, fluorescent property, easiness of synthesis, properties when made into a device, and the like.

The carbon atom number of a portion obtained by removing substituents in such arylene groups is usually 6 to 60, preferably 6 to 20, more preferably about 6 to 18. The total carbon atom number including the substituents of the arylene group is usually 6 to 100, preferably 6 to 80, more preferably about 6 to 70.

Examples of such arylene groups include phenylene groups (for example, groups of the following formulae 1 to 3), naphthalenediyl groups (for example, groups of the following formulae 4 to 13), anthracenediyl groups (for example, groups of the following formulae 14 to 19), biphenyl-diyl groups (for example, groups of the following formulae 20 to 25), terphenyl-diyl groups (for example, groups of the following formulae 26 to 28), fluorine-diyl groups (for example, groups of the following formulae 36 to 38), benzofluorene-diyl (for example, groups of the following formulae 39 to 46), other di-valent condensed poly-cyclic aromatic hydrocarbon groups (for example, groups of the following formulae 29 to 35), and the like.

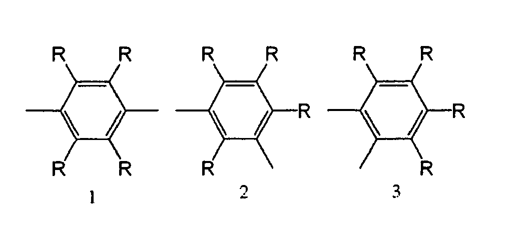

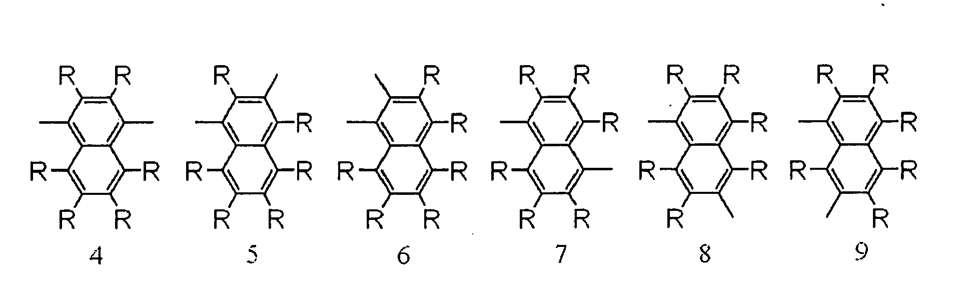

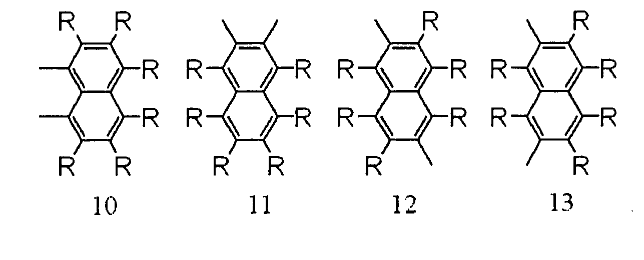

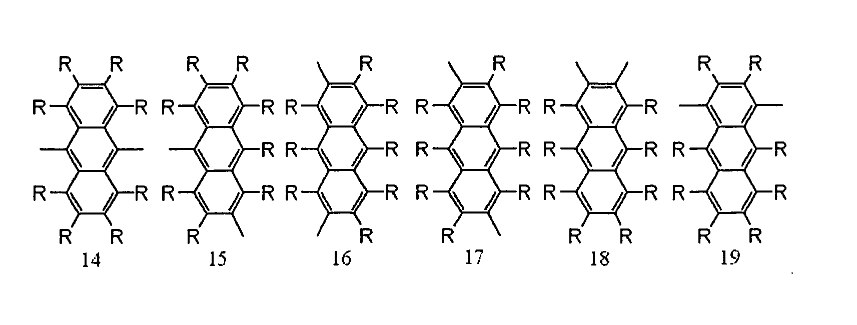

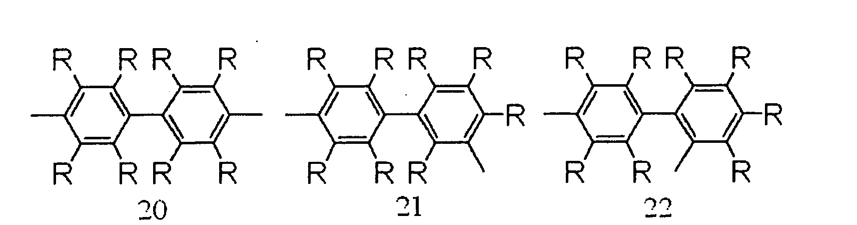

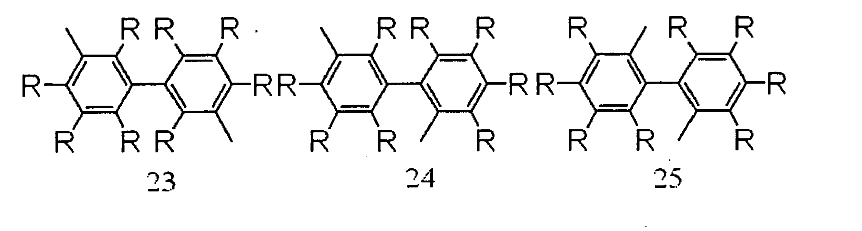

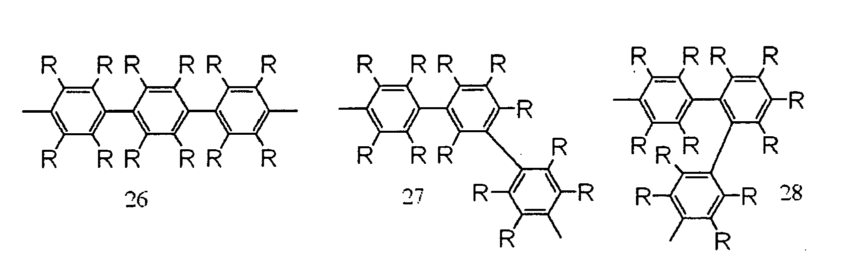

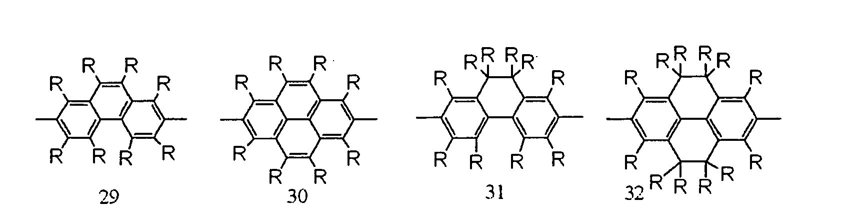

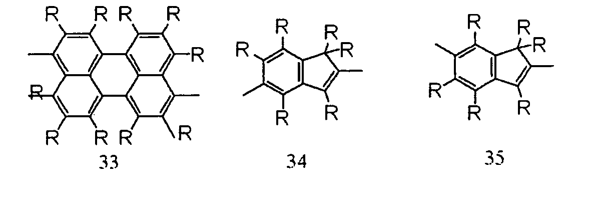

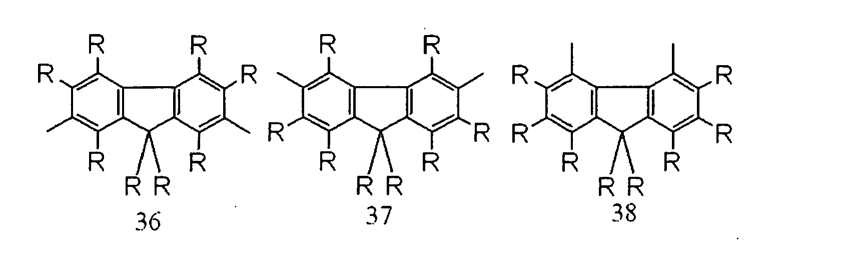

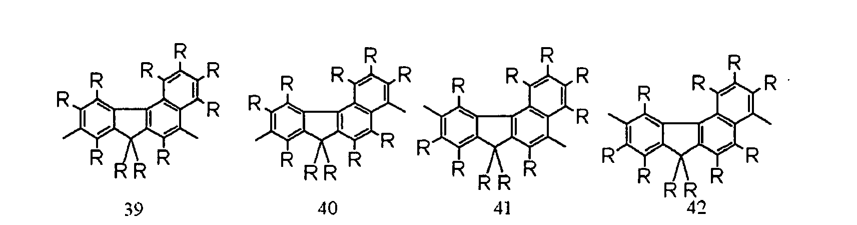

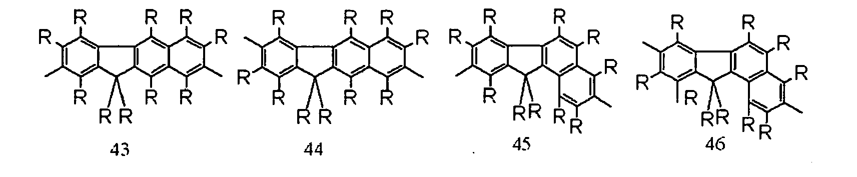

In the above-described formulae 1 to 46, R represents a hydrogen atom, halogen atom, alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclicthio group, amino group, silyl group, acyl group, acyloxy group, imine residue, amide group, acid imide group, carboxyl group, cyano group or nitro group. In the above-described formulae 1 to 46, a plurality of R's may be the same or different.

Among such repeating units of the formula (8), preferable are repeating units of the following formula (9) from the standpoint of the half life of luminance of an organic electroluminescence device of the present invention. 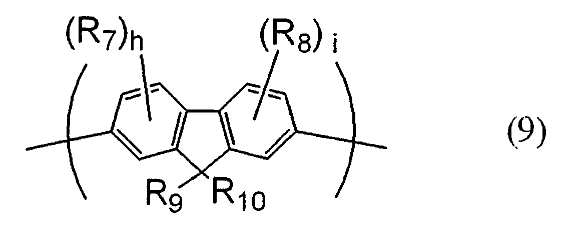 (wherein, R₇ and R₈ may be the same or different, and represent independently a halogen atom, alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclicthio group, amino group, silyl group, acyl group, acyloxy group, imine residue, amide group, acid imide group, carboxyl group, cyano group or nitro group, h and i may be the same or different and represent independently an integer of 0 to 3, and R₉ and R₁₀ may be the same or different and represent independently a hydrogen atom, halogen atom, alkyl group, alkoxy group, alkylthio group, aryl group, aryloxy group, arylthio group, arylalkyl group, arylalkoxy group, arylalkylthio group, arylalkenyl group, arylalkynyl group, mono-valent heterocyclic group, heterocyclicthio group, amino group, silyl group, acyl group, acyloxy group, imine residue, amide group, acid imide group, carboxyl group, cyano group or nitro group, here, when there exist either one or both of a plurality of R₇'s and R₈'s, the plurality of atoms or groups may be the same or different.).

h and i in the above-described formula (9) represent preferably 0 or 1, particularly preferably 0, from the standpoint of easiness of synthesis of raw material monomers.

R₉ and R₁₀ in the above-described formula (9) represent preferably an alkyl group or aryl group, from the standpoint of easiness of synthesis of raw material monomers.

Examples of such repeating units of the formula (9) include repeating units of the following formulae (9-1) to (9-8).

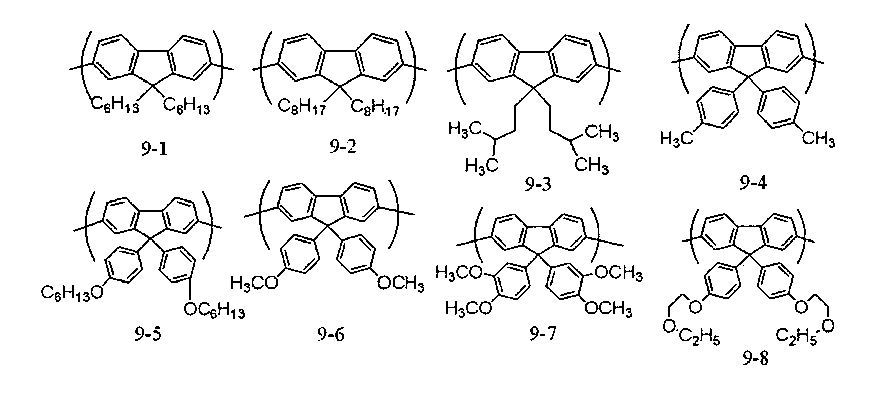

The polymer compound containing a repeating unit composed of an aromatic amine skeleton in the main chain has a polystyrene-equivalent number average molecular weight of preferably about 10³ to 10⁸, more preferably about 10⁴ to 10⁶_{.}

In the present invention, the polystyrene-equivalent "number average molecular weight" and "weight average molecular weight" are measured by using size exclusion chromatography (SEC) (manufactured by Shimadzu Corp.: LC-10 Avp). A sample to be measured is dissolved in tetrahydrofuran so as to give a concentration of about 0.5 wt%, and 50 µL of the solution is injected into SEC. Further, tetrahydrofuran is used as the mobile phase of SEC, and flown at a flow rate of 0.6 mL/min. As the column, two TSKgel SuperHM-H (manufactured by Tosoh Corporation) and one TSKgel SuperH2000 (manufactured by Tosoh Corporation) are serially connected. As the detector, a differential refractive index detector (manufactured by Shimadzu Corp.: RID-10A) is used.

As the method of synthesizing the polymer compound containing a repeating unit composed of an aromatic amine skeleton in the main chain, there are mentioned, for example, a method of polymerization according to the Suzuki coupling reaction from monomers corresponding to the desired polymer compound, a method of polymerization according to the Grignard reaction, a method of polymerization using a Ni(O) catalyst, a method of polymerization using an oxidizer such as FeCl₃ and the like, a method of electrochemical oxidation polymerization, a method by decomposition of an intermediate polymer compound having a suitable leaving group, and the like. Of them, preferable are a method of polymerization according to the Suzuki coupling reaction, a method of polymerization according to the Grignard reaction and a method of polymerization using a Ni(O) catalyst, from the standpoint of easiness of control of the reaction.

In the above-described reaction, alkalis and suitable catalysts can be added appropriately for promotion of the reaction. These alkalis and suitable catalysts may be selected according to the kind of the reaction, and those which are sufficiently dissolved in a solvent to be used in the reaction are preferable. Examples of the alkali include inorganic bases such as potassium carbonate, sodium carbonate and the like; organic bases such as triethylamine, tetraethylammonium hydroxide and the like; inorganic salts such as cesium fluoride and the like. Examples of the catalyst include tetrakis(triphenylphosphine)palladium and palladium acetates.

Since the purity of a polymer compound containing a repeating unit composed of an aromatic amine skeleton in the main chain exerts an influence on the light emission property of a device, it is preferable to purify a monomer before polymerization by a method such as distillation, sublimation purification, re-crystallization and the like before performing polymerization, and it is preferable to perform a refinement treatment such as re-precipitation purification, chromatographic fractionation and the like, after synthesis.

Examples of the solvent to be used in the above-described reaction include saturated hydrocarbons such as pentane, hexane, heptane, octane, cyclohexane and the like; aromatic hydrocarbons such as benzene, toluene, ethylbenzene, xylene and the like; halogenated saturated hydrocarbons such as carbon tetrachloride, chloroform, dichloromethane, chlorobutane, bromobutane, chloropentane, bromopentane, chlorohexane, bromohexane, chlorocyclohexane, bromocyclohexane and the like; halogenated aromatic hydrocarbons such as chlorobenzene, dichlorobenzene, trichlorobenzene and the like; alcohols such as methanol, ethanol, propanol, isopropanol, butanol, t-butyl alcohol and the like; carboxylic acids such as formic acid, acetic acid, propionic acid and the like; ethers such as dimethyl ether, diethyl ether, methyl-t-butyl ether, tetrahydrofuran, tetrahydropyran, dioxane and the like; inorganic acids such as hydrochloric acid, hydrobromic acid, hydrofluoric acid, sulfuric acid, nitric acid and the like. These solvents may be used singly or in combination with another or more.

After the reaction, usual post treatments can be carried out such as, for example, quenching with water before extraction with an organic solvent, distillation off of the organic solvent, and the like, to obtain a coarse polymer compound. As described above, isolation and purification of a polymer compound can be carried out by a method such as chromatographic preparative isolation, re-crystallization and the like.

As the example of the method of synthesizing the above-described polymer compound, mentioned are methods in which a compound of the following formula (10) is polymerized singly, or a compound of the following formula (10) and a compound of the following formula (11) are polymerized, by the above-described methods. 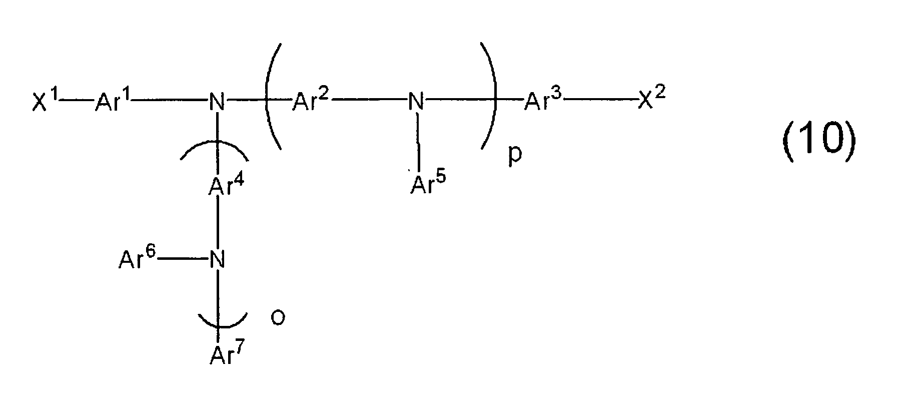 X³-Ar^{B}-X⁴ (11)

(wherein, Ar¹ to Are are as described above, X¹ to X⁴ represent independently a halogen atom, alkylsulfo group, arylsulfo group, arylalkylsulfo group, borate residue, sulfoniummethyl group, phosphoniummethyl group, phosphonatemethyl group, mono-halogenated methyl group, boric residue (-B(OH)₂), formyl group, or vinyl group.).

It is preferable that X¹ to X⁴ represent independently a halogen atom, alkylsulfo group, arylsulfo group, arylalkylsulfo group, borate residue, or boric residue, from the standpoint of synthesis of a compound of the above-described formula (10) or (11) and from the standpoint of easiness of the reaction.

Examples of the alkylsulfo group include a methanesulfo group, ethanesulfo group, trifluoromethanesulfo group and the like. Examples of the arylsulfo group include a benzenesulfo group, p-toluenesulfo group and the like. Examples of the arylalkylsulfo group include a benzylsulfo group and the like.

As the borate residue, for example, groups of the following formulae are mentioned. 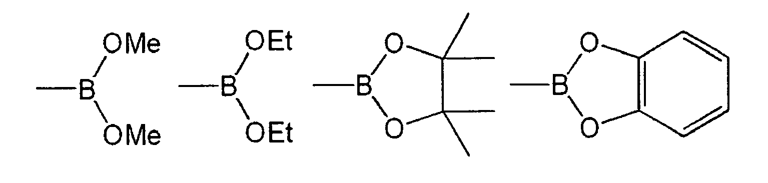 (wherein, Me represents a methyl group, Et represent an ethyl group).

Examples of the sulfoniummethyl group include groups of the following formulae.

-CH₂S⁺Me₂X⁻, -CH₂S⁺Ph₂X⁻

(wherein, X represents a halogen atom, Me represents a methyl group, and Ph represents a phenyl group).

Examples of the phosphoniummethyl group include groups of the following formulae.

-CH₂P+Ph³X⁻

(wherein, X represents a halogen atom, Ph represents a phenyl group).

Examples of the phosphonatemethyl group, groups of the following formulae.

-CH₂PO(OR¹¹)₂

(wherein, R¹¹ represents an alkyl group, aryl group, or arylalkyl group).

Examples of the mono-halogenated methyl group include a methyl fluoride group, methyl chloride group, methyl bromide group an methyl iodide group.

### --- Insolubilization of hole transporting layer ---

In laminating another layer, for example, a light emitting layer showing light emission through recombination of a hole and an electron, onto a hole transporting layer containing a polymer compound containing a repeating unit composed of an aromatic amine skeleton in the main chain (hereinafter, referred to as aromatic amine polymer compound, in some cases), the hole transporting layer is preferably insolubilized for prevention of mixing of both the layers by a common solvent or elution of the hole transporting layer. As the insolubilization treatment, there are exemplified a method in which a soluble precursor of an aromatic amine polymer compound or an aromatic amine polymer compound having a soluble substituent is used, and the precursor is converted into a polymer compound by a thermal treatment or the substituent is decomposed, to lower solubility, attaining insolubilization; an aromatic amine polymer compound having a cross-linkable group in the molecule is used and a cross-linking reaction is caused between the aromatic amine polymer compounds; a method in which a cross-linking agent (monomer or macromer causing a cross-linking reaction by heat, light, electron beam and the like) is further used in this cross-linking reaction; a method in which an aromatic amine polymer compound having no cross-linkable group in the molecule and a cross-linking agent (monomer or macromer causing a cross-linking reaction by heat, light, electron beam and the like) are used and cross-linked; and other methods. Particularly, it is preferable to use a polymer compound having a repeating unit composed of an aromatic amine skeleton in the main chain and having a cross-linkable group in the molecule, and if necessary, to use a cross-linking agent.

Examples of the above-described polymer compound having a repeating unit composed of an aromatic amine skeleton in the main chain and having a cross-linkable group in the molecule include polymer compounds having a repeating unit composed of an aromatic amine skeleton in the main chain and having a cross-linkable group on the side chain. Examples of such a cross-linkable group include a vinyl group, acetylene group, butenyl group, acryloyl group, acryloyloxy group, acrylamide group, methacryloyl group, methacryloyloxy group, methacrylamide group, vinyl ether group, vinylamino group, silanol group, groups having a cross-linkable group having a small ring (for example, cyclopropyl group, cyclobutyl group, epoxy group, oxetane group, diketene group, episulfide group and the like), lactone group, lactam group, or groups containing a siloxane derivative, and the like. In addition to them, combinations of groups which are capable of forming an ester bond or amide bond, and the like, can also be used. For example, a combination of an ester group and an amino group, a combination of an ester group and a hydroxyl group, and the like, are mentioned. Further examples include groups containing a benzocyclobutane structure described in WO 97/09394 and the like. Of them, an acryloyloxy group or methacryloyloxy group is particularly preferable.

Such a polymer compound containing a repeating unit composed of an aromatic amine skeleton in the main chain and having a cross-linkable group in the molecule can be synthesized by polymerizing the corresponding monomers having a cross-linkable group. For example, examples of the mono-functional monomer having an acryloyloxy group or methacryloyloxy group include 2-ethylhexyl carbitol acrylate, 2-hydroxyethyl acrylate and the like. Examples of the bi-functional monomer having an acryloyloxy group or methacryloyloxy group include 1,6-hexanediol diacrylate, 1,6-hexanediol dimethacrylate, ethylene glycol diacrylate, ethylene glycol dimethacrylate, neopentyl glycol diacrylate, neopentyl glycol dimethacrylate, triethylene glycol diacrylate, triethylene glycol dimethacrylate, 3-methylpentanediol diacrylate, 3-methylpentanediol dimethacrylate and the like. Examples of other poly-functional monomers having an acryloyloxy group or methacryloyloxy group include trimethylolpropane triacrylate, trimethylolpropane trimethacrylate, pentaerythritol triacrylate, pentaerythritol trimethacrylate, pentaerythritol tetraacrylate, pentaerythritol tetramethacrylate, dipentaerythritol pentaacrylate, dipentaerythritol pentamethacrylate, dipentaerythritol hexaacrylate, dipentaerythritol hexamethacrylate and the like.

In the above-described polymer compound containing a repeating unit composed of an aromatic amine skeleton in the main chain and having a cross-linkable group in the molecule, the content ratio of the cross-linkable group is usually 0.01 to 30 wt%, preferably 0.5 to 20 wt%, more preferably 1 to 10 wt%.

Examples of the above-described cross-linking agent include those having a polystyrene-equivalent number average molecular weight of 2000 or less and having two or more of the above-described cross-linkable groups, and examples thereof include compounds mentioned above as specific examples of the bi-functional monomer having an acryloyloxy group or methacryloyloxy group, compounds mentioned above as examples of the poly-functional monomers having an acryloyloxy group or methacryloyloxy group, trispentaerythritol octaacrylate (TPEA), and the like.

Examples of the cross-linking reaction of a polymer having a cross-linkable group or a cross-linking agent include reactions occurring by heating, irradiation with light, electron beam and the like. The above-described reaction may also be carried out in the presence of a thermal polymerization initiator, photopolymerization initiator, thermal polymerization initiation aid, photopolymerization initiation aid, or the like.

In the case of insolubilization of a hole transporting layer by heating, the heating temperature is not particularly restricted providing it is lower than temperatures at which the material is decomposed to lower its property, and it is for example 50°C to 300°C, preferably 100°C to 250°C.

In the case of insolubilization of a hole transporting layer by heating, as the thermal polymerization initiator which can be used together, there can be used those known in general as a radical polymerization initiator, and examples thereof include azo compounds such as 2,2'-azobisisobutyronitrile, 2,2'-azobis-(2,4-dimethylvaleronitrile), 2,2'-azobis(4-methoxy-2,4-dimethylvaleronitrile) and the like; organic peroxides such as benzoyl peroxide, lauroyl peroxide, t-butyl peroxypivalete, 1,1'-bis(t-butylperoxy)cyclohexane and the like; and hydrogen peroxide. In the case of use of a peroxide as the radical polymerization initiator, a peroxide may also be used together with a reducing agent to give a redox type initiator. These thermal polymerization initiators may be used singly or in combination with another or more.

The reaction temperature when a thermal polymerization initiator is used together is for example 40°C to 250°C, preferably 50°C to 200°C.

In photopolymerization using a photopolymerization initiator, ultraviolet ray may advantageously be irradiated at an irradiation intensity of 0.01 mw/cm² or more for 1 second to 3600 seconds, preferably for 30 seconds to 600 seconds.

As the photopolymerization initiator, mentioned are active radical generators generating an active radical by irradiation with light, acid generators generating an acid, and the like. Examples of the active radical generator include acetophenone photopolymerization initiators, benzoin photopolymerization initiators, benzophenone photopolymerization initiators, thioxanthone photopolymerization initiators, triazine photopolymerization initiators and the like. The acid generator includes compounds generating an acid directly or indirectly by irradiation with ultraviolet ray, far ultraviolet ray, electron beam, X-ray or the like, for example, trihalomethyltriazine compounds described in JP-A No. 4-163552, disulfone compounds described in JP-A No. 1-57777, and the like. These photopolymerization initiators may be used singly or in combination with another or more.

### [Luminescent material]

In the organic electroluminescent device of the present invention, the light emitting layer is formed preferably between a hole transporting layer containing a polymer compound containing a repeating unit composed of an aromatic amine skeleton in the main chain, and an anode. As the luminescent material used in the light emitting layer, one kind of molecule having functions such as a function of transporting holes, a function of transporting electrons, a function of recombination, a function of light emission, and the like may be used, two or more molecules having a single function or several functions may be used, or, a plurality of molecules having the same function may be used. The luminescent material may have low molecular weight or high molecular weight. Examples of methods for forming a light emitting layer containing them include film formation methods by (co)vapor-deposition or from solution. If the luminescent material is dissolved in a solvent, film formation methods from solution can be used, and if vaporized in vacuum, vapor-deposition methods can also be used.

As the luminescent material to be contained in the light emitting layer, fluorescent materials and triplet light emitting materials described in "Organic EL Display" (Shizuo Tokito, Chihaya Adachi, Yukio Murata joint writing, Ohmsha, Ltd., 2004, first edition, first print issue), p. 17 to 48, p. 83 to 99, p. 101 to 120 can be utilized. As the fluorescent material of low molecular weight, there can be used, for example, naphthalene derivatives, anthracene and derivatives thereof, perylene and derivatives thereof, dyes such as polymethine dies, xanthene dyes, coumarin dyes, cyanine dyes and the like, metal complexes of 8-hydroxyquinoline, metal complexes of 8-hydroxyquinoline derivatives, aromatic amines, tetraphenylcyclopentadiene and derivatives thereof, tetraphenylbutadiene and derivatives thereof and the like. Specifically, known compounds such as those described in, for example, JP-A Nos. 57-51781 and 59-194393, and the like can be used.

Examples of the triple light emitting complex as the triplet light emitting material include Ir(ppy)₃, Btp₂Ir(acac) containing iridium as a center metal, PtOEP containing platinum as a center metal, Eu(TTA)₃phen containing europium as a center metal, and the like.

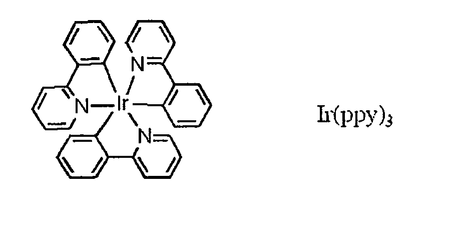

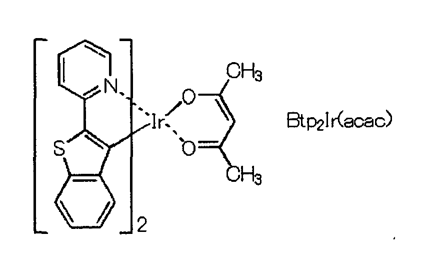

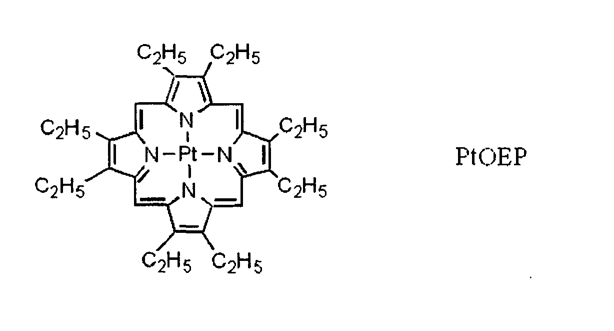

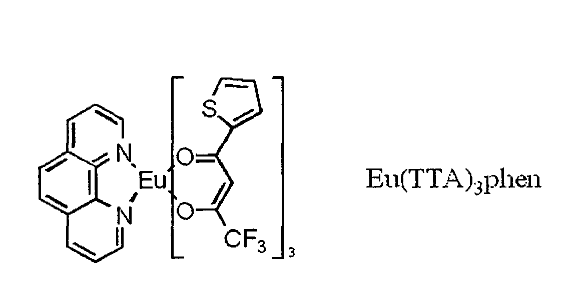

Other examples of the triplet light emitting complex are described in Nature, (1998), 395, 151, Appl. Phys. Lett. (1999), 75(1), 4, Proc. SPIE-Int. Soc. Opt. Eng. (2001), 4105 (Organic Light-Emitting Materials and Devices IV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852 , Jpn.J.Appl.Phys.,34, 1883 (1995) and the like.

The luminescent material used in the present invention may be a polymer compound, and for example, may be any of alternative copolymer, random polymer, block polymer or graft copolymer, and may also be a polymer compound having an intermediate structure between them, for example, a random copolymer having a blocking property. A random copolymer having a blocking property, a block copolymer or graft copolymer is more preferable than a complete random copolymer, since a higher charge transporting performance is manifested, and resultantly, higher light emission efficiency, driving at lower voltage and longer life can be realized. Polymer compounds having branching in the main chain and thus having three or more end parts, and so-called dendrimers, are also included.

In the organic electroluminescent device of the present invention, the luminescent material is preferably a polymer compound containing a repeating unit composed of the above-described aromatic amine skeleton in the main chain since it can improve the light emission efficiency by enhancing hole transportability. From the standpoint of device properties such as maximum light emission efficiency and the like, the proportion of the repeating unit is preferably 0.1 mol% or more and less than 30 mol% with respect to all repeating units in the polymer compound. When it is less than 0.1 mol%, sufficient hole injectability is not obtained in some cases. When it is 30 mol% or more, light emission does not occur and holes reach a cathode as a counter electrode, to lower light emission efficiency, in some cases. Further preferably, the proportion is 0.5 mol% or more and 10 mol% or less with respect to all repeating units in the polymer compound, then, an organic electroluminescent device showing higher light emission efficiency is obtained. As the repeating unit composed of the aromatic amine skeleton, repeating units of the above-described formula (5) can be used.

In the organic EL device of the present invention, when the luminescent material contains at least one repeating unit composed of the above-described aromatic amine skeleton, it is preferable that the luminescent material contains in its main chain at least one repeating unit of the above-described formula (8) together with this, from the standpoint of device properties such as maximum light emission efficiency, device life and the like. The definition, examples and the like of the repeating unit of the above-described formula (8) are as described above.

Further, the luminescent material used in the present invention is preferably a polymer compound having a polystyrene-equivalent number average molecular weight of 1×10³ to 1×10⁸, more preferably a polymer compound having a polystyrene-equivalent number average molecular weight of 1×10³ to 1×10⁶, from the standpoint of the life property of an organic electroluminescent device of the present invention.

As the method of synthesizing a luminescent material containing a repeating unit of the above-described formula (5) and a repeating unit of the above-described formula (8) in the main chain, the same methods as exemplified for synthesis of the above-described polymer compound containing a repeating unit composed of an aromatic amine skeleton in the main chain are mentioned.

### [Electron transportable material]

The organic layer in an organic EL device of the present invention may further contain an electron transporting layer. In this case, as the electron transportable material to be used as the material of the electron transporting layer, known materials can be used, and examples thereof include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, and the like. Specific examples include those described in JP-A Nos. 63-70257, 63-175860, 2-135359, 2-135361, 2-209988, 3-37992 and 3-152184, and the like.

Of them, preferable are oxadiazole derivatives, benzoquinone and derivatives thereof, anthraquinone and derivatives thereof, metal complexes of 8-hydroxyquinoline and derivatives thereof, polyquinoline and derivatives thereof, polyquinoxaline and derivatives thereof, and polyfluorene and derivatives thereof, further preferable are 2-(4-biphenylyl)-5-(4-t-butylphenyl)-1,3,4-oxadiazole, benzoquinone, anthraquinone, tris(8-quinolinol)aluminum, and polyquinoline.

### [Organic electroluminescent device]

In the organic EL device of the present invention, at least a portion in contact with an organic layer of the surface of an anode is treated with an organic compound of the above-described formula (1), or a layer in contact with an anode constituting an organic layer contains the above-described organic compound, alternatively, at least a portion in contact with an organic layer of the surface of an anode is treated with the above-described organic compound and a layer in contact with an anode constituting an organic layer contains the above-described organic compound. On the organic layer between an electrode for hole injection (called anode) and an electrode for electron injection (called cathode), a layer appropriately selected from a hole injection layer, hole transporting layer, a light emitting layer, electron transporting layer and electron injection layer can be laminated. If at least a portion in contact with an organic layer of the surface of an anode is treated with an organic compound of the above-described formula (1), it is not necessary that the above-described organic compound is contained in these layers, while if the above-described portion of the surface of an anode is not treated with the organic compound, it is necessary that the layer in contact with an anode constituting the organic layer contains the organic compound. Typical structures include, but not limited to, structures exemplified below, and other organic layers, electron block layer, hole block layer, electron injection layer, hole injection layer and the like can be inserted at respective effective positions of lamination structure.
anode surface-treated with the above-described organic compound/hole transporting layer/light emitting layer/cathode
anode surface-treated with the above-described organic compound/hole transporting layer/light emitting layer/electron transporting layer/cathode
anode/hole transporting layer containing the above-described organic compound/light emitting layer/cathode
anode/hole transporting layer containing the above-described organic compound/light emitting layer/electron transporting layer/cathode
anode surface-treated with the above-described organic compound/hole transporting layer containing the above-described organic compound/light emitting layer/cathode
anode surface-treated with the above-described organic compound/hole transporting layer containing the above-described organic compound/light emitting layer/electron transporting layer/cathode

Here, / indicates mutual lamination of layers described on both sides of this mark or lamination of a layer and an electrode. Further, a hole transporting layer, light emitting layer and electron transporting layer may be used each singly, or two or more layers having the same function may be laminated.

Examples of the material which can be used in the organic layer in an organic electroluminescent device of the present invention include charge transportable materials and luminescent materials used in low molecular weight type organic electroluminescent devices and high molecular weight type organic electroluminescent devices. Examples of light emission colors include medium colors and white color in addition to three primary colors of red, blue and green. In a full color device, materials showing light emission of three primary colors are suitably used, and in a flat light source, materials showing light emission of white color and medium colors are suitably used.

In the organic electroluminescent device of the present invention, the thickness of the whole organic layer shows an optimum value differing depending on the material to be used, and may be adjusted so that driving voltage, light emission efficiency and device life show suitable values, and for example, it is 30 nm to 1 µm, preferably 40 nm to 500 nm, further preferably 60 nm to 400 nm.

The thicknesses of layers contained in the organic layer are selected appropriately so as to give desired values of light emission efficiency and driving voltage, and it is generally 5 nm to 200 nm. Examples of the thickness of the hole transporting layer containing a polymer compound containing a repeating unit composed of an aromatic amine skeleton in the main chain include thicknesses from 10 to 300 nm, and thicknesses from 20 to 150 nm are preferable. Examples of the thickness of the light emitting layer being capable of emitting light through recombination of a hole and an electron include thicknesses from 5 to 300 nm , thicknesses from 30 to 200 nm are preferable, and thicknesses from 40 to 150 nm are further preferable. Examples of the thickness of the hole block layer include thicknesses from 5 to 50 nm, and thicknesses from 10 to 30 nm are preferable. Examples of the thickness of the electron transporting layer, thicknesses from 10 to 100 nm, and thicknesses from 20 to 80 nm are preferable.

Examples of the method of forming these layers include methods of film formation by a coating method and a printing method if a solution or emulsion can be formed, in addition to vacuum processes such as vacuum vapor deposition, cluster vapor deposition, molecular beam vapor deposition and the like.

Particularly, in the present invention, methods of film formation from solution and the like are used, for production of a hole transporting layer containing a polymer compound containing a repeating unit composed of an aromatic amine skeleton in the main chain, a light emitting layer being capable of emitting light through recombination of a hole and an electron, and an electron transporting layer.

As the method of film formation from solution, for example, coating methods such as a spin coat method, casting method, micro gravure coat method, gravure coat method, bar coat method, roll coat method, wire bar coat method, dip coat method, spray coat method, screen printing method, flexo printing method, offset printing method, inkjet print method, nozzle coat method, capillary coat method and the like can be used. Of them, printing methods such as a screen printing method, flexo printing method, offset printing method, inkjet print method and the like are preferable since pattern formation and multi-color separate painting are easy.

In the above-described method of film formation from solution, an ink is usually used. This ink contains a polymer compound containing a repeating unit composed of an aromatic amine skeleton in the main chain, and a solvent. Though this solvent is not particularly restricted, preferable are those capable of dissolving or uniformly dispersing components other than the solvent constituting the above-described ink, namely, a polymer compound containing a repeating unit composed of an aromatic amine skeleton in the main chain, a luminescent material, and the like. Examples of the above-described solvent include chlorine-based solvents such as chloroform, methylene chloride, 1,2-dichloroethane, 1,1,2-trichloroethane, chlorobenzene, o-dichlorobenzene and the like; ether solvents such as tetrahydrofuran, dioxane and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketone solvents such as acetone, methyl ethyl ketone, cyclohexanone and the like; ester solvents such as ethyl acetate, butyl acetate, ethylcellosolve acetate and the like; polyhydric alcohols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like and derivatives thereof; alcohol solvents such as methanol, ethanol, propanol, isopropanol, cyclohexanol and the like; sulfoxide solvents such as dimethyl sulfoxide and the like; amide solvents such as N-methyl-2-pyrrolidone, N,N-dimethylformamide and the like. The above-described solvents may be used singly or in combination with another or more.

Among them, preferable from the standpoint of the solubility of a polymer compound containing a repeating unit composed of an aromatic amine skeleton in the main chain, a luminescent material and the like, uniformity in film formation, viscosity property and the like are aromatic hydrocarbon solvents, aliphatic hydrocarbon solvents, ester solvents and ketone solvents, and toluene, xylene, ethylbenzene, diethylbenzene, trimethylbenzene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, 2-propylcyclohexanone, 2-heptanone, 3-heptanone, 4-heptanone, 2-octanone, 2-nonanone, 2-decanone and dicyclohexylketone are preferable, and it is more preferable that at least one of xylene, anisole, cyclohexylbenzene and bicyclohexyl is contained.

The proportion of the solvent in the ink is 1 wt% to 99.9 wt%, preferably 60 wt% to 99.5 wt%, further preferably 80 wt% to 99.0 wt% with respect to the solute (that is, the total amount of a polymer compound containing a repeating unit composed of an aromatic amine skeleton in the main chain, and a luminescent material).

Though the viscosity of the ink varies depending on the printing method, the viscosity is preferably in the range of 1 to 20 mPa•s at 25°C in the case of passing of an ink through a discharge apparatus such as in an inkjet print method and the like, for preventing clogging and curving of flying in discharging.

Examples of the material for a high molecular weight organic electroluminescent device include materials described in "Polymer EL Material" (Toshihiro Onishi, Tamami Koyama joint writing, Kyoritsu Publication, 2004, initial edition, first print publication), p. 33 to 58 are exemplified, and an organic electroluminescent device can be fabricated with a structure in which a light emitting layer is laminated on a charge injection layer or a charge transporting layer. Specific examples of hole transporting materials, electron transporting materials and luminescent materials as polymer compounds include polyfluorene, derivatives thereof and copolymers thereof, polyarylene, derivatives thereof and copolymers thereof, polyarylenevinylene, derivatives thereof and copolymers thereof, and (co)polymers of aromatic amines and derivatives thereof disclosed in WO 99/13692, WO 99/48160, GB 2340304A, WO 00/53656, WO 01/19834, WO 00/55927, GB 2348316, WO 00/46321, WO 00/06665, WO 99/54943, WO 99/54385, US 5777070, WO 98/06773, WO 97/05184, WO 00/35987, WO 00/53655, WO 01/34722, WO 99/24526, WO 00/22027, WO 00/22026, WO 98/27136, US 573636, WO 98/21262, US 5741921, WO 97/09394, WO 96/29356, WO 96/10617, EP 0707020, WO 95/07955, JP-A Nos. 2001-181618, 2001-123156, 2001-3045, 2000-351967, 2000-303066, 2000-299189, 2000-252065, 2000-136379, 2000-104057, 2000-80167, 10-324870, 10-114891, 9-111233, 9-45478, and the like. In the luminescent materials and charge transportable materials, the luminescent materials and charge transportable materials for the low molecular weight type organic electroluminescent device described above may be mixed.

In each of the hole transportable material, electron transportable material and luminescent material, the above-described low molecular weight material and high molecular weight material can be used together. For example, a metal complex having an organic ligand can be used together, and particularly, it is effective to simultaneously use those known as low molecular weight fluorescent materials and phosphorescent materials, so-called triplet light emission complexes and the like. As the center metal of a metal complex having an organic ligand as a luminescent material, for example, aluminum, zinc, beryllium, iridium, platinum, gold, europium, terbium and the like are mentioned.

An insulation layer having a thickness of 10 nm or less may be provided in contact with a cathode. The material of the insulation layer includes metal fluorides, metal oxides, organic insulation materials and the like, preferably, metal fluorides and metal oxides of alkali metals or alkaline earth metals and the like.

Examples of the method of film formation of the inorganic compound used in the insulation layer include a vacuum vapor deposition method.

The substrate used for formation of an organic electroluminescent device of the present invention may advantageously be one which does not change in forming an electrode and each layer of the device, and for example, substrates made of glass, plastic, polymer film, silicon and the like are exemplified. In the case of an opaque substrate, it is preferable that an electrode nearer to the substrate and an electrode on the opposite side are transparent or semitransparent. Here, "transparent" indicates that when a light having a wavelength of 750 to 400 nm passes through the electrode, the ratio of the transmitted light intensity to the incident light intensity (transmission ratio) is 90 to 100%. "Semitransparent" indicates that the above-described transmission ratio is 40% or more and less than 90%.

The anode and cathode in an organic electroluminescent device of the present invention will be described below.

In the organic electroluminescent device of the present invention, if at least one of the anode and cathode is transparent or semitransparent, the generated light passes through the electrode, thus, the emitted light taking out efficiency is excellent advantageously.

In the present invention, it is preferable that the anode side is transparent or semitransparent. As the material of the anode, electrically conductive metal oxides, semitransparent metals and the like are used. Specifically used are electrically conductive glasses (NESA and the like) composed of indium oxide, zinc oxide, tin oxide, and composite thereof: indium•tin•oxide (ITO), indium•zinc•oxide and the like, gold, platinum, silver, copper and the like, and preferable are ITO, indium•zinc•oxide and tin oxide. As the anode, organic transparent electrically conductive films made of polyaniline and its derivative, polythiophene and its derivative, and the like may also be used. The above-described anode materials may be used singly or in combination with another or more.

The thickness of the anode can be appropriately selected in view of light transmission and electric conductivity, and it is for example 10 nm to 10 µm, preferably 20 nm to 1 µm, further preferably 50 nm to 500 nm.

As the method for fabricating an anode, a vacuum vapor deposition method, sputtering method, ion plating method, plating method and the like are mentioned.

In the organic electroluminescent device of the present invention, as the material of the cathode, materials of small work function are preferable, and for example, alkali metals such as lithium, sodium, potassium, rubidium, cesium and the like, alkaline earth metals such as beryllium, magnesium, calcium, strontium, barium and the like, other metals such as aluminum, scandium, vanadium, zinc, yttrium, indium, cerium, samarium, europium, terbium, ytterbium and the like, alloys made of two or more of them, or alloys made of at least one of them and at least one of gold, silver, platinum, copper, manganese, titanium, cobalt, nickel, tungsten and tin, graphite, graphite intercalation compounds and the like are used. Examples of the alloy include magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. The cathode may be composed of one layer or of two or more layers. The above-described cathode materials may be used singly or in combination with another or more.

The thickness of the cathode can be appropriately adjusted in view of electric conductivity and durability, and it is, for example, 10 nm to 10 µm, preferably 20 nm to 1 µm, further preferably 50 nm to 500 nm.

For cathode fabrication, a vacuum vapor deposition method, sputtering method, lamination method of thermally press-bonding a metal thin film, and the like are used. A layer made of an electrically conductive polymer, or a layer made of a metal oxide, metal fluoride, organic insulation material and the like (usually, a layer having an average film thickness of 2 nm or less) may be provided between a cathode and an organic layer.

After manufacturing a cathode, a protective layer for protecting the organic electroluminescent device may be installed. For use of the organic electroluminescent device stably for a long period of time, it is preferable to install a protective layer and/or protective cover, for protecting a device from outside.

As the protective layer, a polymer compound, metal oxide, metal nitride, metal nitroxide, metal fluoride, metal boride and the like can be used. As the protective cover, a glass plate, and a plastic plate having a surface subjected to low water permeation treatment, and the like can be used, and a method of pasting the cover to a device substrate with a thermosetting resin or photo-curable resin to attain close sealing is suitably used. When a space is maintained using a spacer, prevention of blemishing of a device is easy. If an inert gas such as nitrogen, argon and the like is filled in this space, oxidation of a cathode can be prevented, further, by placing a drying agent such as barium oxide, calcium oxide and the like in this space, it becomes easy to suppress moisture adsorbed in a production process from imparting damage to the device. It is preferable to adopt one strategy among these methods.

### [Application]

The organic electroluminescent device of the present invention can be used as a sheet light source, segment display, dot matrix display, backlight of a liquid crystal display, and the like.

For obtaining light emission in the form of sheet using an organic electroluminescent device of the present invention, it may be advantages to place a sheet anode and a sheet cathode so as to overlap. For obtaining light emission in the form of pattern, there are a method in which a mask having a window in the form of pattern is placed on the surface of the sheet light emitting device, a method in which an organic substance layer in non-light emitting parts is formed with extremely large thickness to give substantially no light emission, and a method in which either anode or cathode, or both electrodes are formed in the form pattern. By forming a pattern by any of these methods, and placing several electrodes so that On/Off is independently possible, a display of segment type is obtained which can display digits, letters, simple marks and the like.
Further, for providing a dot matrix device, it may be permissible that both an anode and a cathode are formed in the form of stripe, and placed so as to cross. By using a method in which several polymers showing different emission colors are painted separately or a method in which a color filter or a fluorescence conversion filter is used, partial color display and multi-color display are made possible. In the case of a dot matrix device, passive driving may be permissible, and active driving in combination with a thin film transistor using an amorphous silicon or low temperature polysilicon may also be permissible. These displays can be used as a display of a computer, television, portable terminal, cellular telephone, car navigation, view finder of video camera, and the like.

Further, the above-described sheet light emitting device is of self emitting and thin type, and can be suitably used as a sheet light source for back light of a liquid crystal display, or as a sheet light source for illumination. If a flexible substrate is used, it can also be used as a curved light source or display.

### EXAMPLES

Examples and Comparative Examples will be shown below for illustrating the present invention further in detail, but the invention is not limited to them.

### <Synthesis Example 1> (Synthesis of polymer compound Ahole transportable polymer compound --)

Into a flask connected to Dimroth was added 5.25 g (9.9 mol) of a compound A of the following structural formula: 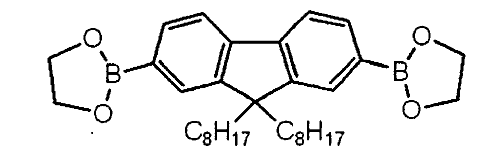 4.55 g (9.9 mol) of a compound B of the following structural formula: 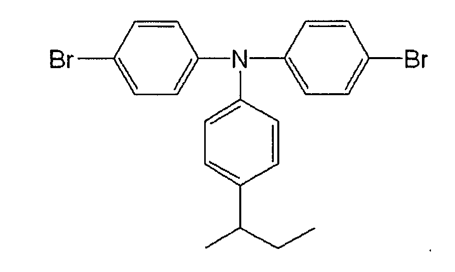 0.91 g of methyltrioctylammonium chloride (trade name: Aliquat 336, manufactured by Aldrich) and 69 ml of toluene, to obtain a monomer solution. Under a nitrogen atmosphere, the monomer solution was heated, and at 80°C, 2 mg of palladium acetate and 15 mg of tris(2-methylphenyl)phosphine were added. Into this monomer solution, 9.8 g of a 17.5 wt% sodium carbonate aqueous solution was poured, then, the mixture was stirred at 110°C for 19 hours. Next, 121 mg of phenylboric acid dissolved in 1.6 ml of toluene was added and the mixture was stirred at 105°C for 1 hour.

The organic phase was separated from the aqueous phase, then, 300 ml of toluene was added to the organic phase. The organic phase was washed with 40 ml of a 3 wt% acetic acid aqueous solution (twice) and 100 ml of ion exchanged water (once) in this order, and separated from the aqueous phase. To the organic phase was added 0.44 g of sodium N,N-diethyldithiocarbamate tri-hydrate and 12 ml of toluene, and the mixture was stirred at 65°C for 4 hours.

A toluene solution of the reaction product was allowed to pass through a silica gel/alumina column through which toluene had been passed previously, and this solution was dropped into 1400 ml of methanol to cause precipitation of a polymer, and the precipitate was filtrated, then, dried to obtain a solid. This solid was dissolved in 400 ml of toluene, and the solution was dropped into 1400 ml of methanol to cause precipitation of a polymer, and the precipitate was filtrated, then, dried to obtain 6.33 g of a polymer (hereinafter, referred to as "polymer compound A"). The polymer compound A had polystyrene-equivalent number average molecular weight and weight average molecular weight of Mn = 8.8×10⁴ and Mw = 3.2×10⁵, respectively.

The resultant polymer compound A is guessed to contain repeating units of the following structural formulae: 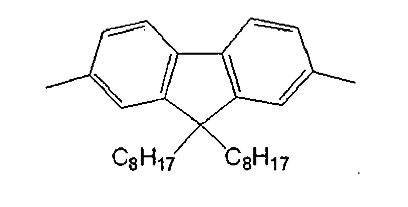 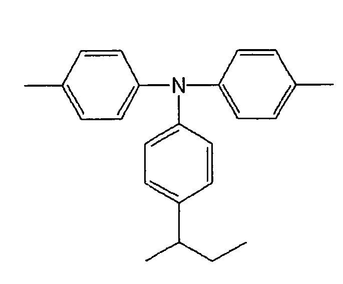 at a ratio of 1:1 (by mole) according to the charged raw materials.

### <Synthesis Example 2> (Synthesis of polymer compound Bluminescent material --)

Into a reaction vessel was charged 0.647 g of Aliquat336, 2.626 g of the compound A, 0.683 g of a compound C of the following structural formula: 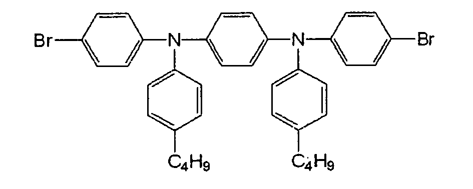 and 2.194 g of a compound D of the following structural formula: 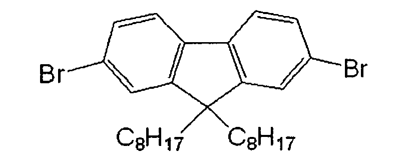 , and purging with nitrogen was performed. Next, 50 ml of argon gas-bubbled toluene was added, and bubbling was further carried out for 30 minutes while stirring. Next, 1.1 mg of palladium acetate and 12.3 mg of tris(2-methoxyphenyl)phosphine were added, then, 10 ml of a 17.5 wt% sodium carbonate aqueous solution was added, and the mixture was stirred at a bath temperature of 95°C for 3 hours. Thereafter, 90 mg of phenylboric acid was added, and the mixture was stirred at a bath temperature of 95°C for 2 hours.

The reaction solution was cooled, then, 60 g of toluene was added and the solution was stirred, then, allowed to stand still to cause liquid separation, and the organic phase was recovered. Next, to this organic phase was added a mixed solution of 3.0 g of sodium N,N-diethyldithiocarbamate tri-hydrate/50 g of ion exchanged water, and the mixture was stirred at room temperature for 3 hours.

Next, the organic phase was separated from the aqueous phase, then, to this organic phase was added 200 ml of toluene. This organic phase was washed with ca. 3 wt% acetic acid aqueous solution and ion exchanged water in this order, then, the organic phase was poured slowly into methanol, to cause re-precipitation of a polymer. The generated precipitate was filtrated and recovered, and dried under reduced pressure, then, dissolved in about 400 ml of toluene. This toluene solution was allowed to pass through an alumina column, then, the resultant toluene solution was poured slowly into about 1500 ml of methanol, to cause re-precipitation of a polymer. The generated precipitate was filtrated and recovered, and dried under reduced pressure to obtain 2.3 g of a polymer. This polymer is called polymer compound B.

The resultant polymer compound B had polystyrene-equivqlent number average molecular weight and weight average molecular weight of Mn = 1.7×10⁵ and Mw = 3.3×10⁵, respectively.

### <Synthesis Example 3> (Synthesis of polymer compound Cluminescent material --)

Into a 200 mL separable flask was added 3.18 g (6.0 mmol) of 9,9-dioctylfluorene-2,7-diboric acid ethylene glycol ester, 3.06 g (5.4 mmol) of 9,9-dioctyl-2,7-dibromofluorene, 0.44 g (0.6 mmol) of N,N'-bis(4-bromophenyl)-N,N'-bis(2,6-dimethyl-4-tert-butylphenyl)-1,4-phenylenediamine, 0.82 g of methyltrioctylammonium chloride (trade name:Aliquat336, manufactured by Aldrich) and 60 mL of toluene, to obtain a monomer solution. Under a nitrogen atmosphere, to the monomer solution was added 4.2 mg of bistriphenylphosphine palladium dichloride and the mixture was heated at 85°C. Into this monomer solution, 16.3 mL of a 17.5 wt% sodium carbonate aqueous solution was dropped while heating up to 105°C, then, the mixture was stirred for 1.5 hours. Next, 0.74 g phenylboric acid, 4.2 mg of bistriphenylphosphine palladium dichloride and 30 mL of toluene were added, and the mixture was stirred at 105°C for 17 hours.

The organic phase was separated from the aqueous phase, then, to the organic phase was added 3.65 g of sodium N,N-diethyldithiocarbamate tri-hydrate and 36 mL of ion exchanged water, and the mixture was stirred at 85°C for 2 hours. The organic phase was separated from the aqueous phase, then, the organic phase was washed with 80 mL of ion exchanged water (twice), 80 mL of a 3 wt% acetic acid aqueous solution (twice) and 80 mL of ion exchanged water (twice) in this order, and separated from the aqueous phase.

The organic phase was dropped into 930 mL of methanol to cause precipitation of a polymer, and the precipitate was filtrated, then, dried to obtain a solid. This solid was dissolved in 190 mL of toluene, and the solid toluene solution was allowed to pass through a silica gel/alumina column through which toluene had been passed previously, and the eluate was dropped into 930 mL of methanol to cause precipitation of a polymer, and the precipitate was filtrated, then, dried to obtain 4.17 g of a polymer. Hereinafter, this polymer is called polymer compound C. The polymer compound C had polystyrene-equivalent number average molecular weight and weight average molecular weigh of Mn = 2.7×10⁵ and Mw = 7.1×10⁵, respectively.

### <Example 1>

### (Fabrication of EL device)

A glass substrate carrying thereon an ITO film with a thickness of 150 nm formed by a sputtering method was treated with UV ozone for 15 minutes. Thereafter, the glass substrate was reacted with 1H,1H,2H,2H-perfluorooctyltrichlorosilane, a silane coupling agent manufactured by Fluka. 500 µl of 1H,1H,2H,2H-perfluorooctyltrichlorosilane and 25 ml of octane were mixed, and the substrate was immersed in the solution for 22 hours to cause a reaction thereof. On this glass substrate, the polymer compound A was spin-coated in the form of xylene solution, to form a film with a thickness of 10 nm. The film was thermally treated on a hot plate at 180°C for 15 minutes. Next, on the film-formed polymer compound A, the polymer compound B was spin-coated in the form of xylene solution, to form a film with a thickness of 75 nm. Thereafter, the film was heated at 130°C for 60 minutes on a hot plate under a nitrogen atmosphere, to remove the solvent. Thus fabricated thin film was introduced into a vacuum vapor deposition machine, and as a cathode, metal barium was vapor deposited with a thickness of about 5 nm, then, aluminum was vapor deposited with a thickness of about 100 nm, to obtain an EL device. After the degree of vacuum reached 1×10⁻⁴ Pa or less, vapor deposition of metal was initiated.

### (Evaluation of EL device)

### (1) Confirmation of light emission color

When voltage was applied to the device obtained above, blue EL light emission was observed. The light emission spectrum was measured to find a peak wavelength of 460 nm, confirming blue light emission ascribable to the polymer compound B. The light emission initiation voltage at 1 cd/cm² was 3.4 V. The maximum light emission efficiency was 2.99 cd/A, and the current density at 9 V was 169 mA/cm².

### (2) Life

The current value was set so that the driving current was 2 mA, then, the EL device obtained above was driven at constant current, and change in luminance with time was measured. As a result, the luminance decreased to 80% after 1.71 hours and decreased to half after 4.3 hours.

### <Comparative Example 1>

An organic electroluminescent device was fabricated in the same manner as in Example 1 excepting that the glass substrate was not reacted with 1H,1H,2H,2H-perfluorooctyltrichlorosilane, a silane coupling agent manufactured by Fluka, in Example 1. When voltage was applied to the resultant device, blue light emission having a peak wavelength of 460 nm derived from the polymer compound B was shown, and the light emission initiation voltage at 1 cd/cm² was 6.4 V. The maximum light emission efficiency was 0.10 cd/A, and the current density at 9 V was 70 mA/cm². When the current value was set at 2 mA and the device was driven at constant current, the luminance decreased to 80% after 0.8 hours and decreased to half after 1.3 hours.

### <Comparative Example 2>

An organic electroluminescent device was fabricated in the same manner as in Example 1 excepting that the polymer compound A was not film-formed, in Example 1. When voltage was applied to the resultant device, blue light emission having a peak wavelength of 460 nm derived from the polymer compound B was shown, and the light emission initiation voltage at 1 cd/cm² was 3.4 V. The maximum light emission efficiency was 2.72 cd/A, and the current density at 9 V was 242 mA/cm². When the current value was set at 2 mA and the device was driven at constant current, the luminance decreased to 80% after 0.38 hours and decreased to half after 0.96 hours.

### <Comparative Example 3>

An organic electroluminescent device was fabricated in the same manner as in Example 1 excepting that the glass substrate was not reacted with 1H,1H,2H,2H-perfluorooctyltrichlorosilane, a silane coupling agent manufactured by Fluka and the polymer compound A was not film-formed, in Example 1. When voltage was applied to the resultant device, blue light emission having a peak wavelength of 460 nm derived from the polymer compound B was shown, and the light emission initiation voltage at 1 cd/cm² was 4.7 V. The maximum light emission efficiency was 1.44 cd/A, and the current density at 9 V was 88 mA/cm². When the current value was set at 2 mA and the device was driven at constant current, the luminance decreased to 80% after 0.01 hour and decreased to half after 0.04 hours.

### <Example 2>

### (Fabrication of EL device)

A glass substrate carrying thereon an ITO film with a thickness of 150 nm formed by a sputtering method was treated with UV ozone for 15 minutes. Thereafter, the glass substrate was reacted with 1H,1H,2H,2H-perfluorooctyltrichlorosilane, a silane coupling agent manufactured by Fluka. 500 µl of 1H,1H,2H,2H-perfluorooctyltrichlorosilane and 25 ml of octane were mixed, and the substrate was immersed in the solution for 17 hours to cause a reaction thereof. On this glass substrate, the polymer compound A was spin-coated in the form of xylene solution, to form a film with a thickness of 20 nm. The film was thermally treated on a hot plate at 180°C for 60 minutes. Next, on the film-formed polymer compound A, the polymer compound C was spin-coated in the form of xylene solution, to form a film with a thickness of 75 nm. Thereafter, the film was heated at 130°C for 10 minutes on a hot plate under a nitrogen atmosphere, to remove the solvent. Thus fabricated thin film was introduced into a vacuum vapor deposition machine, and as a cathode, metal barium was vapor deposited with a thickness of about 5 nm, then, aluminum was vapor deposited with a thickness of about 100 nm, to obtain an EL device. After the degree of vacuum reached 1×10⁻⁴ Pa or less, vapor deposition of metal was initiated.

### (Evaluation of EL device)

### (1) Confirmation of light emission color

When voltage was applied to the device obtained above, blue EL light emission was observed. The light emission spectrum was measured to find a peak wavelength of 450 nm, confirming blue light emission ascribable to the polymer compound C. The light emission initiation voltage at 1 cd/cm² was 3.2 V. The maximum light emission efficiency was 3.82 cd/A, and the current density at 9 V was 118 mA/cm².

### (2) Life

The current value was set so that the driving current was 2 mA, then, the EL device obtained above was driven at constant current, and change in luminance with time was measured. As a result, the luminance decreased to 80% after 0.9 hours and decreased to half after 6.8 hours.

### <Comparative Example 4>

An organic electroluminescent device was fabricated in the same manner as in Example 2 excepting that α-NPD manufactured by Aldrich was film-formed by a vacuum vapor deposition method instead of film formation of the polymer compound A, in Example 2. Vacuum vapor deposition of α-NPD was initiated after the degree of vacuum reached 5×10⁻⁴ Pa or less. When voltage was applied to the resultant device, blue light emission having a peak wavelength of 450 nm derived from the polymer compound C was shown, and the light emission initiation voltage at 1 cd/cm² was 3.4 V. The maximum light emission efficiency was 2.20 cd/A, and the current density at 9 V was 128 mA/cm². When the current value was set at 2 mA and the device was driven at constant current, the luminance decreased to 80% after 0.25 hours and decreased to half after 1.1 hours.

### <Comparative Example 5>

An organic electroluminescent device was fabricated in the same manner as in Example 2 excepting that the glass substrate was not reacted with 1H,1H,2H,2H-perfluorooctyltrichlorosilane, a silane coupling agent manufactured by Fluka and α-NPD manufactured by Aldrich was film-formed by a vacuum vapor deposition method instead of film formation of the polymer compound A, in Example 2. When voltage was applied to the resultant device, blue light emission having a peak wavelength of 450 nm derived from the polymer compound C was shown, and the light emission initiation voltage at 1 cd/cm² was 5.8 V. The maximum light emission efficiency was 0.51 cd/A, and the current density at 9 V was 55 mA/cm². When the current value was set at 2 mA and the device was driven at constant current, the luminance decreased to 80% after 0.06 hours and decreased to half after 0.01 hour.

### <Example 3>

### (Fabrication of EL device)

A glass substrate carrying thereon an ITO film with a thickness of 150 nm formed by a sputtering method was treated with UV ozone for 15 minutes. Thereafter, the glass substrate was reacted with 1H,1H,2H,2H-perfluorooctyltrichlorosilane, a silane coupling agent manufactured by Fluka. 500 µl of 1H,1H,2H,2H-perfluorooctyltrichlorosilane and 25 ml of octane were mixed, and the substrate was immersed in the solution for 17 hours to cause a reaction thereof. Next, the polymer compound A in the form of xylene solution and a cross-linking agent dipentaerythritol hexaacrylate (manufactured by Nippon Kayaku Co. Ltd., trade name: "KAYARAD DPHA") were mixed to obtain a coating solution (the proportion of the cross-linking agent was 20 wt% with respect to the sum of the polymer compound A and the cross-linking agent), this coating solution was spin-coated on the above-described glass substrate to form a film with a thickness of 80 nm. The film was thermally treated on a hot plate at 180°C for 60 minutes to cross-link the polymer compound A with dipentaerythritol hexaacrylate, obtaining a thin film composed of cross-linked polymer compound A. On this thin film, the polymer compound C was spin-coated in the form of xylene solution, to form a film with a thickness of 75 nm. Thereafter, the film was heated at 130°C for 10 minutes on a hot plate under a nitrogen atmosphere, to remove the solvent. Thus fabricated thin film was introduced into a vacuum vapor deposition machine, and as a cathode, metal barium was vapor deposited with a thickness of about 5 nm, then, aluminum was vapor deposited with a thickness of about 100 nm, to obtain an EL device. After the degree of vacuum reached 1×10⁻⁴ Pa or less, vapor deposition of metal was initiated.

### (Evaluation of EL device)

### (1) Confirmation of light emission color

When voltage was applied to the device obtained above, blue EL light emission was observed. The light emission spectrum was measured to find a peak wavelength of 450 nm, confirming blue light emission ascribable to the polymer compound C. The light emission initiation voltage at 1 cd/cm² was 4.8 V. The maximum light emission efficiency was 4.24 cd/A, and the current density at 9 V was 11 mA/cm².

### (2) Life

The current value was set so that the driving current was 2 mA, then, the EL device obtained above was driven at constant current, and change in luminance with time was measured. As a result, the luminance decreased to 80% after 0.66 hours.

### <Example 4>

### (Fabrication of EL device)

An organic electroluminescent device was fabricated in the same manner as in Example 3, excepting that the thickness of the above-described coating solution was changed from 80 nm to 20 nm, in Example 3.

### (Evaluation of EL device)

### (1) Confirmation of light emission color

When voltage was applied to the device obtained above, blue EL light emission was observed. The light emission spectrum was measured to find a peak wavelength of 450 nm, confirming blue light emission ascribable to the polymer compound C. The light emission initiation voltage at 1 cd/cm² was 3.7 V. The maximum light emission efficiency was 3.53 cd/A, and the current density at 9 V was 36 mA/cm².

### (2) Life

The current value was set so that the driving current was 2 mA, then, the EL device obtained above was driven at constant current, and change in luminance with time was measured. As a result, the luminance decreased to 80% after 0.56 hours.

### Industrial Applicability

Production of the organic electroluminescent device of the present invention is easy since an alternative material for PEDDT:PSS is used, from the standpoint of production processes such as coating, film formation and the like. The organic electroluminescent device of the present invention usually has long life, and further shows high light emission efficiency. The organic electroluminescent device of the present invention can be preferably used in apparatuses such as segment type displays, dot matrix flat panel displays and the like. It can be also used as a backlight of liquid crystal displays, or a curved or flat light source for illumination.

## Claims

1. An organic electroluminescent device comprising
an anode,
a cathode, and
an organic layer composed of at least two layers including a hole transporting layer containing a polymer compound,the main chain of which contains repeating units each composed of an aromatic amine skeleton , and a light emitting layer containing a luminescent material and being capable of emitting light through recombination of a hole and an electron, wherein
at least one of the anode and the cathode is transparent or semitransparent,
the organic layer is disposed in contact with the anode between the anode and the cathode,
at least a portion of the surface of the anode ,the portion being in contact with the organic layer, is treated with an organic compound of the following formula (1):
(X)ᵥ₋₁-M-R¹ (1)
wherein each X represents a group or atom capable of reacting with a group or atom present on the surface of the anode to form a bond, M represents an atom of a metal element belonging to Group IV, Group V, Group VI, Group XIII, Group XIV or Group XV of the periodic table, R¹ represents independently an alkyl group, an aryl group, an arylalkyl group, an arylalkenyl group or an arylalkynyl group, and v represents the atomic valency of M, and/or, a layer that constituts the organic layer and that is in contact with the anode contains the organic compound.

2. The organic electroluminescent device according to Claim 1, wherein the polymer compound contained in the hole transporting layer has been insolubilized.

3. The organic electroluminescent device according to Claim 2, wherein the polymer compound has been insolubilized through a cross-linking reaction.

4. The organic electroluminescent device according to Claim 3, wherein the insolubilized polymer compound is obtained by insolubilizing a polymer compound having a cross-linkable group in its molecule through a cross-linking reaction of the cross-linkable group.

5. The organic electroluminescent device according to Claim 3, wherein the cross-linking reaction has been carried out using a cross-linking agent.

6. The organic electroluminescent device according to any one of Claims 1 to 5, wherein the luminescent material is a polymer compound having a polystyrene-equivalent number average molecular weight of 1×10³ to 1×10⁸.

7. The organic electroluminescent device according to any one of Claims 1 to 6, wherein a hydroxyl group is present on the surface of the anode, and the organic compound of the formula (1) includes either one or both of a silane coupling agent of the following formula (2):
(X)₃-Si-R¹ (2)
wherein X and R¹ are as described above.
and a titanium coupling agent of the following formula (3):
(X)₃-Ti-R¹ (3)
wherein, X and R¹ are as described above.

8. The organic electroluminescent device according to any one of Claims 1 to 7, wherein the organic compound of the formula (1) is an organic compound of the following formula (4):
(A)₃-Si-B (4)
wherein, A's represent each independently a chlorine atom or hydroxyl group, and B represents an alkyl group having 2 to 10 carbon atoms.

9. The organic electroluminescent device according to any one of Claims 1 to 8, wherein the organic layer further includes an electron transporting layer.

10. A sheet light source having the organic electroluminescent device according to any one of Claims 1 to 9.

11. A segment display having the organic electroluminescent device according to any one of Claims 1 to 9.

12. A dot matrix display having the organic electroluminescent device according to any one of Claims 1 to 9.

13. A liquid crystal display having a backlight composed of the organic electroluminescent device according to any one of Claims 1 to 9.
